(19) **Europäisches Patentamt**
**European Patent Office**
**Office européen des brevets**

(11) **EP 2 622 713 B1**

(12) **EUROPEAN PATENT SPECIFICATION**

(45) Date of publication and mention
of the grant of the patent:
**30.11.2016  Bulletin 2016/48**

(51) Int Cl.:
*H02J 13/00* *(2006.01)*    *H02J 3/00* *(2006.01)*

(21) Application number: **11832893.9**

(22) Date of filing: **18.04.2011**

(86) International application number:
**PCT/US2011/032840**

(87) International publication number:
**WO 2012/050635 (19.04.2012 Gazette 2012/16)**

(54) **SYSTEM AND METHOD TO MANAGE POWER USAGE**

SYSTEM UND VERFAHREN ZUR  STROMVERBRAUCHSVERWALTUNG

SYSTÈME ET PROCÉDÉ DE GESTION DE CONSOMMATION ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **29.09.2010  PCT/US2010/050714
29.09.2010  US 893539
14.02.2011  US 201113026931
13.01.2011  US 201161432399 P**

(43) Date of publication of application:
**07.08.2013  Bulletin 2013/32**

(73) Proprietor: **The Powerwise Group, Inc.
Boca Raton, FL 33487 (US)**

(72) Inventors:
• **LUMSDEN, John, L.
Denton, Texas 76208 (US)**

• **ZAGA, Rafael, E.
Aventura
FL 33160 (US)**

(74) Representative: **Roberts, Peter David
Marks & Clerk LLP
1 New York Street
Manchester M1 4HD (GB)**

(56) References cited:
**EP-A2- 2 267 867      WO-A1-94/06191
WO-A1-95/22190      WO-A1-2009/023106
GB-A- 2 426 878      US-A1- 2003 062 878
US-A1- 2006 049 694      US-A1- 2006 049 694
US-A1- 2006 125 422      US-A1- 2009 046 490
US-A1- 2010 145 542      US-A1- 2010 145 542
US-A1- 2010 191 385      US-A1- 2010 191 385**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

1. Field of the Invention

This invention relates to the management of electrical power usage.

2. Description of the Related Art

Since the industrial revolution, the world's consumption of energy has grown at a steady rate. Most power generated and energy consumed is from the combustion of fossil fuels, which is a non-renewable natural resource that is rapidly becoming depleted. As the depletion of Earth's natural resources continues, power generation and energy conservation has become an increasingly important issue with governments in both this country and abroad. In addition, businesses and consumers are also concerned as the costs for such resources are rapidly increasing.

Not only do there exist worldwide concerns with power generation and energy conservation, but there also exist concerns with power distribution, especially in emerging economies. Although power generation and energy conservation are of great importance, the problem of power distribution is also of great concern as it involves existing infrastructure that is usually inadequate for properly distributing power. Moreover, it is not readily suitable to be improved upon.

Electricity for residential and industrial use is typically generated at an electric power generating station, and sent through transmission lines in an electricity grid to a distribution system, which carries the electricity to the consumer. In many parts of the world, electric power supply has not kept up with demand, often resulting in brownouts, and sometimes blackouts. A brownout is a drop in voltage in the electrical power supply, often resulting in dimming of lighting when the voltage sags. Brownout voltages sometimes drop enough to cause appliances or equipment to stop operating. Such appliances or equipment may sustain permanent damage as a result of the low voltage condition.

In extreme occurrences of electric power demand exceeding supply, blackouts may occur. A blackout occurs when the supply voltage cannot be sustained at all, or is reduced to a dangerously low level, such as to cause electric motors to stall and overheat. The times of blackouts are generally known to the electrical company from historical records of heavy demand.

A brownout may be caused by (1) inadequate power generation, (2) insufficient power transmission capacity, and/or (3) insufficient power distribution capacity. Inadequate power generation and insufficient power transmission are easier to remedy than insufficient power distribution capacity. Both power generation demand and power transmission capacity can be calculated and fulfilled comparatively easily within fiscal budgets.

The main obstacle to providing sufficient power to consumers is insufficient power distribution capacity. The need for power distribution capacity cannot be easily planned for or economically implemented. Moreover, as the world population grows, and industrial participation in the world economy increases, the power distribution infrastructure will be increasingly strained or overloaded by the additional loads placed on it. The distribution problems can often be attributed to copper losses within the cabling that forms the distribution infrastructure.

Currently, governmental entities and power companies attempt to remedy brown out occurrences by elevating the AC voltage or adding power shedding generation at appropriate locations on the power grid. This method usually results in a wide disparity of voltages available to consumers in homes and/or business. The voltage increases may range from ten percent to fifteen percent (10%-15%) and, since power is calculated by Voltage$^2$/load, the result of the governmental entities' and power companies' "remedy" can result in increased charges to the consumer of up to twenty-five percent (25%). Thus, rather than conserving energy, governmental entities and power companies are expending energy.

Furthermore, although most appliances and equipment used in businesses and homes are capable of performing, exactly to specification, at the nominal voltage minus ten percent (10%), most energy savings devices do not exploit this feature. Thus, a further potential for energy savings is oftentimes ignored.

A transformer transfers electrical energy from one circuit to another through inductively coupled conductors. A varying current in the first or primary windings creates a varying magnetic flux in the transformer's core, and thus a varying magnetic field through the secondary windings. If a load is connected to the secondary, an electric current will flow in the secondary windings and electrical energy will be transferred from the primary circuit through the transformer to the load. The ratio of the transformer is the number of turns in the secondary windings to the number of turns in the primary windings.

The solution to the power distribution problem often employed is to boost the incoming voltage to allow sensitive appliances to continue operating. One solution has been to use motor driven Variac type transformers that continuously adjust the voltage to the nominal voltage. However, this solution requires mechanical implementation that is prone to failure. A second solution has been to employ electronic solid-state boosters that continuously adjust the voltage to the nominal voltage. However, this solution is expensive and inefficient. A third solution is to use relay switched transformers. The problem with this solution is that the mechanical contacts are prone to failure with the high currents being switched. Finally, manually switched transformers have been tried. This solution is undesirable because it requires a person in attendance, and the transformer can be inadvertently left in the boost position. Each of the above solutions of the past has problems of safety, efficiency, cost, complexity and/or reliability. The solutions of the past that utilize transformers and switching perform the switching on the transformer secondary windings side, where disadvantageous high currents are present. There is also a disadvantageous interruption of current with such prior solutions during the switching period.

Pub. No. U.S. 2009/0051344 proposes a TRIAC/SCR-based energy savings device, system and method wherein a predetermined amount of voltage below a nominal line voltage and/or below a nominal appliance voltage is saved. Pub. No. U.S. 2009/0200981 proposes a system and method for providing constant loading in AC power applications wherein at least one turn-on point of at least one half cycle of a modulating sine wave is determined, at least one turn-off point of the at least one half cycle of the modulating sine wave is determined, and at least one slice located between the at least one turn-on point and the at least one turn-off point in removed. Pub. No. U.S. 2010/0033155 proposes a power supply for IGBT/FET drivers that provides separated, isolated power to each IGBT/FET driver.

U.S. Patent No. 6,489,742 proposes a motor controller that includes power conveyance to an induction motor with a digital signal processor that calculates and optimizes supply of current for existent motor loading from a power supply and main voltage through a control element. Pub. No. U.S. 2010/0117588 proposes a motor controller for maximizing the energy savings in an AC induction motor at every load wherein the motor is calibrated at two or more load points to establish a control line, which is then programmed into a non-volatile memory of the motor controller. Pub. No. U.S. 2010/0320956 proposes a closed loop motor controller to reduce the supply voltage to a pump jack electric motor when the motor would be generating energy in open loop mode.

A need exists for a system and method to manage energy usage that reduces brown outs, blackouts, and costs.

BRIEF SUMMARY OF THE INVENTION

During a first predetermined time period, such as when blackouts are not anticipated, a digital signal processor (DSP) controls an IGBT/FET-based device to supply a predetermined voltage that is less than the AC incoming line voltage or mains input voltage. Phase input connections are provided for inputting analog signals into the device and system. A magnetic flux concentrator or a current transformer senses the incoming analog signal and a volts zero crossing point detector determines the zero volts crossing point of the signal. The positive half cycle and negative half cycle of the signal is identified and routed to the DSP for processing the signal. The signal is reduced by a driver control via pulse width modulation and the reduced amount of energy is outputted, thereby yielding an energy savings for an end user.

A microprocessor measures the AC incoming line voltage, and compares it with the predetermined voltage. When the AC incoming line voltage is higher than the predetermined voltage, the microprocessor controls a switch on the primary windings side of a transformer to short circuit the primary windings. When the measured voltage is less than the predetermined voltage, and voltage increase is needed, such as during a brownout condition, the microprocessor controls the switch to connect one end of the primary windings to neutral, removing the short circuit from the transformer and allowing the secondary voltage to add to the AC incoming line voltage to provide a boosted output voltage to the predetermined voltage through the hot output line of the secondary windings side of the transformer. The secondary windings are not switched.

During a second predetermined time period, such as when blackout conditions are anticipated, the DSP controls the IGBT/FET-based device to supply an allocated amount of power. The DSP and/or the microprocessor monitors power consumption, which may be displayed. When the power consumption exceeds the allocated amount of power, the DSP may shut off the power.

Alternatively, when the consumed power exceeds the allocated power, a signal may be sent alerting the need to reduce power usage. The signal may be audible, visible, or other means. The power consumer may reduce the load to meet the allocated power requirement. In one embodiment, wirelessly controlled electrical outlets may be used to selectively reduce the load in response to the signal. If the load has not been adequately reduced after a predetermined amount of time, the DSP may shut off power. The consumer may then reduce some load, and initiate a command to turn on the power. The command may be initiated by changing the condition of a switch, including manually and/or wirelessly. If the load has still not been adequately reduced after the power has been restored, then the DSP may again shut off the power. Alternatively, the DSP may provide another signal that may again alert that the load must be reduced. If the consumed power is not sufficiently reduced after a predetermined amount of time, then the DSP may shut off power for the duration of the second predetermined time period.

Further alternatively, when the consumed power exceeds the allocated power, the DSP may shut off power to predetermined electrical outlets, while providing power to other electrical outlets, to reduce the overall power usage to the allocated power amount. Predetermined consumer preferences may be implemented. The system may use wirelessly controlled electrical outlets that may be automatically shut-down to meet the predetermined power amount. The system may be monitored, operated and adjusted wirelessly.

The claimed invention is defined by the appended claims.

BRIEF DESCRIPTION OF THE DRAWINGS

In the following detailed description, reference will be made to the attached drawings in which:

FIG. 1 is a block diagram of an IGBT/FET-based device and system for use in a three-phase electrical system.
FIG. 2 is perspective plan view of a sensing means.
FIG. 3 is a circuit diagram of a sensing means.
FIG. 4 is a circuit diagram of a signal conditioning means.
FIG. 5 is an oscillogram for a volts zero crossing point determining means.
FIG. 6 is a circuit diagram for a volts zero crossing point determining means.
FIG. 7 is circuit diagram of a loss detecting means and phase rotation determination and rotating means.
FIG. 8 is a circuit diagram of a half cycle identifying means.
FIG. 9 is an oscillogram of a half cycle identifying means.
FIG. 10 is an oscillogram of a half cycle identifying means.
FIG. 11A is a circuits diagram of the routing means.
FIG. 11B is a continuation of the circuit diagram of FIG. 11A.
FIG. 11C is a circuit diagram of a ports programmer of FIGS. 11A and 11B.
FIG. 11D is a circuit diagram of a resistor support of FIGS. 11A and 11B.
FIG. 11E is a circuit diagram of a connector of FIGS. 11A and 11B.
FIG. 12A is an oscillogram of a voltage reducing means.
FIG. 12B is an oscillogram of a voltage reducing means of the IGBT-based invention.
FIG. 12C is a circuit diagram of an IGBT-based voltage reducing means.
FIG. 12D is a circuit diagram of a drive circuitry for the IGBT-based voltage reducing means of FIG. 12C.
FIG. 12E is a oscillogram of a voltage reducing means of the FET-based invention.
FIG. 12F is a circuit diagram of a FET-based voltage reducing means.
FIG. 12G is a circuit diagram of a drive circuitry for the FET-based voltage reducing means of FIG. 12F.
FIG. 13 a circuit diagram of a combined resetting means and indicator means.
FIG. 14A is a circuit diagram of a power supply unit of a powering means.
FIG. 14B is a continuation of the circuit diagram of FIG. 14A.
FIG. 15A is a circuit diagram a communication means.
FIG. 15B is a circuit diagram of a USB interface of a communications means of FIG. 15A.
FIG. 15C is a circuit diagram of an isolator block of a communications means of FIG. 15A.
FIG. 15D is a circuit diagram of a first connector of a communications means of FIG. 15A into a digital signal processor.
FIG. 15E is a circuit diagram of a second connector of a communications means of FIG. 15A.
FIG. 16 is a screen shot of a windows interface.
FIG. 17 is a screen shot of a windows interface.
FIGS. 18A is a partial circuit diagram of a first embodiment of a voltage booster apparatus showing a transformer and an electronic switch with two solid state relays.
FIG. 18B is a partial circuit diagram of a first embodiment of a voltage booster apparatus showing a DC power supply.
FIG. 18C is a partial circuit diagram of a first embodiment of a voltage booster apparatus showing a microprocessor.
FIG. 19 is a partial circuit diagram of a second embodiment of a voltage booster apparatus showing the wiring arrangement for an exemplary 120V transformer.
FIG. 19A is a partial circuit diagram of a second embodiment of a voltage booster apparatus showing the wiring arrangement for an exemplary 230V transformer.
FIG. 19B is a partial circuit diagram of a second embodiment of a voltage booster apparatus showing DC power supplies and related circuitry.
FIG. 19C is a partial circuit diagram of a second embodiment of a voltage booster apparatus showing a microprocessor and two diode bridge circuits each connected with an IGBT device.
FIG. 20 is a block diagram of a signal module connected with the DSP shown in FIG. 1.

DETAILED DESCRIPTION OF THE INVENTION

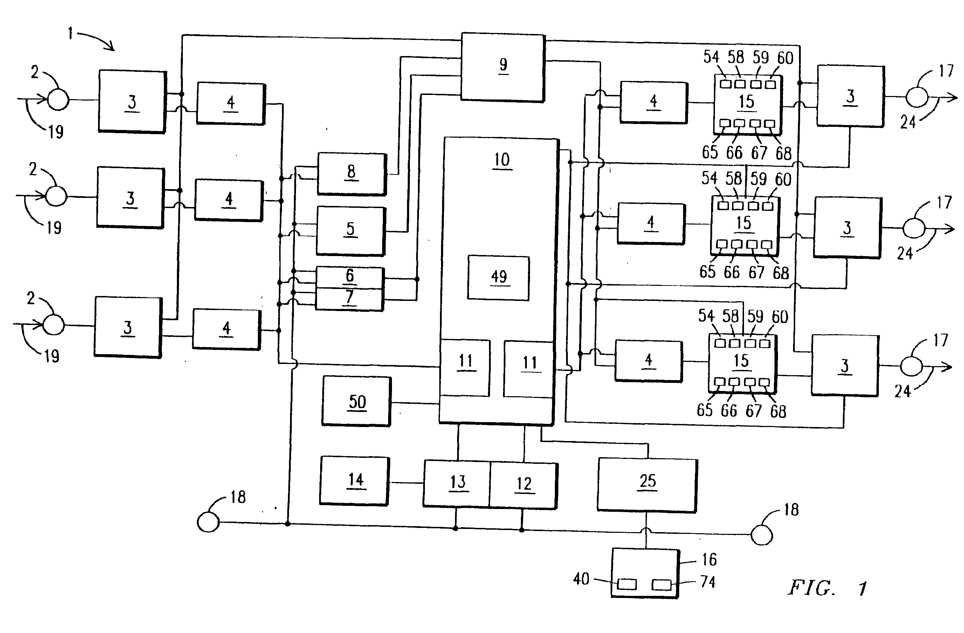

The terminology used in reference to the numbered components in FIGS. 1-17 is as follows:

1. IGBT/FET-based energy savings device and system, generally
2. phase input connection
3. magnetic flux concentrator
4. analog signal conditioning device
5. volts zero crossing point detector
6. lost phase detection device
7. phase rotation device
8. half cycle identifier
9. logic device
10. digital signal processor
11. A/D converter
12. power supply unit
13. reset switch
14. light emitting diode
15. IGBT/FET drive control
16. computing device
17. phase output connection
18. neutral
19. incoming energy
20. analog signal
21. volts zero crossing point
22. positive half cycle
23. negative half cycle
24. reduced energy
25. USB communications interface
26. circuit board
27. housing
28. conductor
29. housing top half
30. housing bottom half
31. hinge
32. first filter
33. second filter
34. comparator
35. Schmidt buffer
36. absolute zero cross signal
37. magnetic flux concentrator chip
38. aperture
39. incoming sine wave
40. windows interface
41. main monitoring screen
42. field, generally
43. operational mode field
44. phase field
45. startup field
46. calibration field
47. setpoints field
48. indicators
49. real time clock
50. digital electricity meter
51. Schmidt-triggered inverting buffer
52. transorb device
53. diode
54. positive half cycle control transistor
55. FET
56. capacitor
57. transformer
58. negative half cycle control transistor

59. IGBT first shunt control transistor

60. IGBT second shunt control transistor

61. shunt device

62. integrated circuit

63. resistor

64. split rail generator

65. optical isolator

66. optically-coupled driver

67. FET first shunt control transistor

68. FET second shunt control transistor

69. square wave

70. operational amplifier

71. isolator

72. rectifier

73. transistor

74. USB port

75. Zener diode

76. first connector

77. second connector

78. inductor

79. resistor support

80. logic device connector

81. linear voltage regulator

82. positive half cycle drive signal applied to positive half cycle control transistor

83. negative half cycle drive signal applied to negative half cycle control transistor

84. drive signal applied to positive half cycle control transistor during negative half cycle

85. drive signal applied to negative half cycle control transistor during positive half cycle

86. drive signal applied to IGBT first shunt control transistor during negative half cycle

87. drive signal applied to IGBT second shunt control transistor during positive half cycle

88. drive signal applied to FET first shunt control transistor during negative half cycle

89. drive signal applied to FET second shunt control transistor during positive half cycle

90. switching regulator

With reference to FIG. 1, a block diagram of an energy savings device and system **1** for use in a three-phase electrical system is shown. The energy savings device and system **1** includes various components and means for reducing the amount of energy inputted wherein the reduced energy yields a virtually non-existent or minimal effect on the performance of an electronically-operated device.

A predetermined amount of incoming energy **19** having at least one analog signal **20** therein is inputted into the device and system **1** via an inputting means, which is preferably at least one phase input connection **2**. A neutral **18** line is also provided in the device and system **1**. As shown in FIG. 1, the system and device **1** is utilized in a three-phase electrical system having an A-B-C phase plus neutral for use as a reference point and as a sink for a clamped back-EMF that is produced when the current in a lagging power factor load is interrupted. However, the energy savings system **1** may be utilized in a single phase system and/or a bi-phase system as well, wherein the only difference in structure is the amount of phase input connections **2** (*e.g.*, in a single phase system, only one phase input connection **2** is utilized in addition to a neutral connection (A) and in a bi-phase system, two phase input connections **2** are utilized (A & B) in addition to a neutral connection).

At least one phase input connection **2** is connected to at least one sensing means, which is at least one magnetic flux concentrator **3** that senses the predetermined amount of incoming energy **19**. It is also contemplated that at least one current transformer may be used instead of the at least one magnetic flux concentrator **3** for all embodiments. The magnetic flux concentrator **3** galvanically isolates the current of the incoming energy **19** and reports any over-current conditions to a routing means, which is preferably at least one logic device **9**. If there are any over-current conditions, then the over-current conditions are simultaneously reported to the logic device **9** and a processing means, which is preferably a digital signal processor **10**, wherein the digital signal processor **10** immediately shuts down the device and system **1**. This electronic breaker action is intended to safeguard the device and system **1** itself, as well as the terminal equipment used in conjunction with the device and system **1** in the event of a short circuit or overload. Thus, the logic device **9** provides total protection of the power control devices in the event of a software/firmware glitch and/or power line glitch or surge in real-time as the reaction time of the logic device **9** and digital signal processor **10** is preferably 5µs. The logic device **9** arbitrates between the drive signals applied to the IGBT/FET half cycle control transistors **54** and **58** and the signals applied to the IGBT/FET shunt control transistors **59, 60, 67** and **68.** Therefore, it avoids the IGBT/FET half cycle control transistors **54** and **58** and IGBT/FET shunt control transistors **59, 60, 67** and **68** from being simultaneously driven to an on-condition that could lead to the failure of the power control and/or shunt elements. The digital signal processor **10** preferably includes at least one A/D converter **11.**

Prior to reporting the analog value of the phase current from the phase input connection **2** to the digital signal processor **10,** the magnetic flux concentrator **3** or current transformer first transmits the incoming energy **19** through at least one signal conditioning means, which is preferably at least one analog signal conditioning device **4.** After the signal(s) have been conditioned, a method which is described below, the conditioned signals are then sent to a volts zero crossing point determining means, which is preferably at least one volts zero crossing point detector **5,** for detecting the point where the AC voltage goes through zero volts relative to neutral **18,** which is commonly referred to as a zero crossing point.

After the zero crossing point is detected and if using a three-phase electrical system, the conditioned signal then enters at least one loss detecting means, which is preferably at least one lost phase detection device **6** and at least one phase rotation determination and rotating means, which is preferably at least one phase rotation device **7,** so as to prepare the signal for proper inputting into at least one half cycle identifying means, which is preferably at least one half cycle identifier **8,** and then the logic device **9** and digital signal processor **10.** Details of the half cycle identifier **8** are discussed below.

The power control is executed via at least one voltage reducing means, which preferably includes at least one IGBT/FET drive control **15,** in electrical connection with the digital signal processor **10** to reduce the energy a predetermined amount. Prior to the processed signals entering the reducing means, however, the signals may once again be conditioned through at least one analog signal conditioning device **4** so as to clean a signal to remove any spurious signals or transient signals. The command signals to exercise control of the IGBT/FET drive control **15** of the voltage reducing means are determined by the digital signal processor **10** and mitigated by the logic device **9.**

The reduced energy **24** then enters at least one magnetic flux concentrator **3** or current transformer and then enters at least one outputting means, which is preferably at least one phase output connection **17,** and is outputted to an electrically-operated device for consumption.

The system and device **1** is powered via a powering means, which is preferably a power supply unit **12** in electrical connection with the digital signal processor **10.** A resetting means, which is preferably a reset switch **13,** is preferably provided to permit a user to reset the device and system **1** as desired. In addition, an indicator means, such as a light emitting diode **14,** may be in electrical connection with reset switch **13** so as to alert a user if the device and system 1 needs to be reset.

The device and system 1 may optionally include at least one digital electricity meter 50 and at least one communication means, such as a USB communications interface **25,** capable of interfacing with at least one computing device **16** having at least one USB port **74** and at least one window interface **40,** via wired or wireless transmission. The USB communications interface **25** permits a user to monitor, display and/or configure the device and system **1** via his/her computing device **16.** However, inclusion of the USB communications interface **25** is not necessary in the implementation of the device and system **1.** In addition, a real time clock **49** may optionally be incorporated within the digital signal processor **10** of or otherwise connected to the energy savings device and system **1.**

A user may determine the operational manner in which to use the energy savings device and system **1,** *e.g.,* a user may select how he/she would like to save energy by either inputting the desired RMS value, inputting the desired percentage voltage or inputting the desired percentage savings reduction into a computing device **16.** For example, if a user chooses to reduce the incoming voltage by a fixed percentage, the energy savings device and system **1** permits such voltage percentage reduction and automatically lowers the voltage so as to be consistent with a maximum allowed harmonic content by establishing a lower voltage threshold. The lower voltage threshold assures that in lower or brown-out conditions, the system and device **1** does not continue to attempt to reduce the available voltage by the percentage reduction specified.

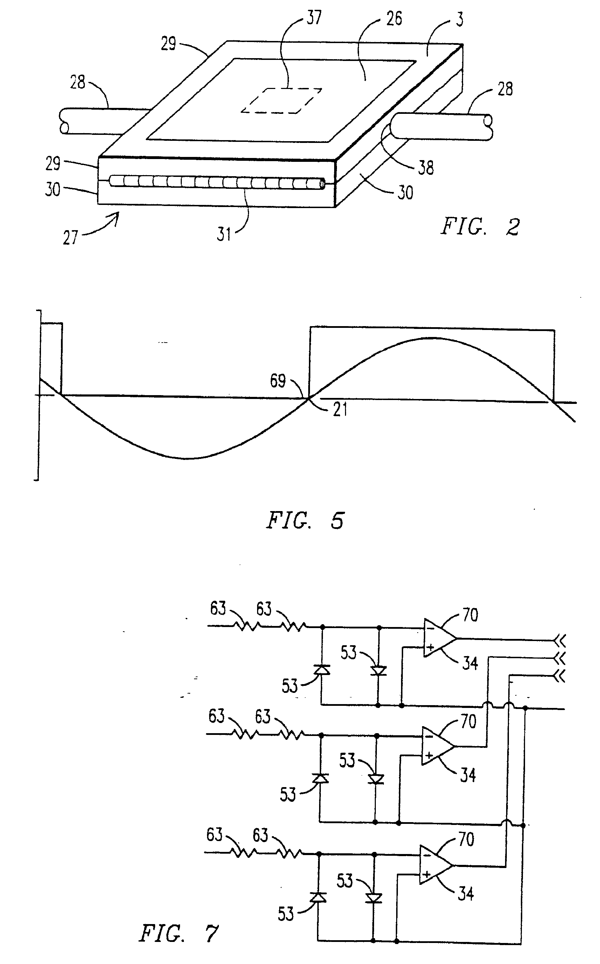

FIG. 2 is perspective plan view of a sensing means. The sensing means, which is at least one magnetic flux concentrator **3** or at least one current transformer, measures AC current galvanically when connected to active circuitry of the device and system **1** of the present invention. A housing **27,** which preferably is made of plastic, includes a housing top half **29** and a housing bottom half **30** and a hinge **30** connecting the two halves **29** and **30,** carries a circuit board **26** having a magnetic flux concentrator chip **37** mounted on the bottom side of the housing top half **29.** Each half **29** and **30** includes at least one notched portion wherein when the halves **29** and **30** are joined together, at least one aperture **38** is formed for permitting a conductor **28** to extend therethrough. The utilization of said housing **27** accurately defines the distance between the magnetic flux concentrator chip **37** and the core center of the conductor **28.** A window detector associated with the magnetic flux concentrator chip **37** accurately determines when current, within the negative or positive half cycles, is out of a normal ranges. In addition, the magnetic flux concentrator **3** uses an open collector Schmidt buffer to allow multiple concentrators **3** to be connected to both the analog signal conditioning device **4** and the logic device **9.**

The housing **27** snaps together and bears on the conductor **28,** which is preferably a cable, to ensure that the conductor **28** is held firmly against the housing **27.** The housing top half **29** may be formed in various sizes so as to accommodate differing wire gauges. A plurality of apertures **38** of various sizes may be formed when the halves **29** and **30** are snapped together so as to accommodate conductors **28** of various widths. The magnetic flux concentrator **3** provides galvanic isolation of the incoming energy **19,** performs accurate current measurement, is adaptable to any range of currents through multiple cable passages located within the housing **27,** provides high voltage galvanic isolation, has zero harmonic distortion and superb linearity. In addition, since the current measurement range is determined by mechanical means, no changes are necessary to the printed circuit board **26**. The following equation determines the approximate sensitivity:

$$V_{out} = 0.06*I/(D+0.3mm)$$

where I = current in the conductor **28** and D = the distance in mm from the top surface of the magnetic flux concentrator chip **37** to the center of the conductor **28.**

Since no electrical connection is made to the measurement target, full galvanic isolation is achieved. Moreover, there is zero insertion loss and, therefore, no heat is dissipated nor energy lost as there is no electrical connection made nor is a shunt or a transformer used.

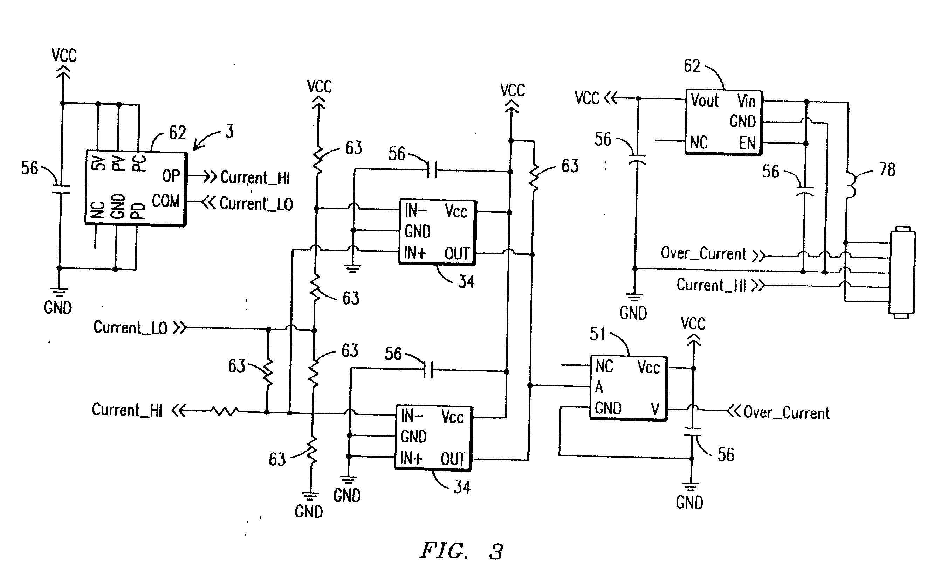

FIG. 3 is a circuit diagram of the sensing means. The magnetic flux concentrator **3** measures the magnetic flux generated when an alternating electric current flows within the conductor **28**. Over-current is accomplished by comparators **34** that form a window comparator. When the thresholds set by resistors **63** are exceeded by an output of the magnetic flux concentrator **3,** which may yield a "Current_Hi" signal, open collector outputs of comparators **34** go low and pass to the logic device **9** and a microprocessor non-maskable input to shut-down the device and system **1**. To avoid ground loop problems, the magnetic flux concentrator **3** preferably includes an integrated circuit **62** that regulates the operational voltage of the magnetic flux concentrator **3** to 5VDC.

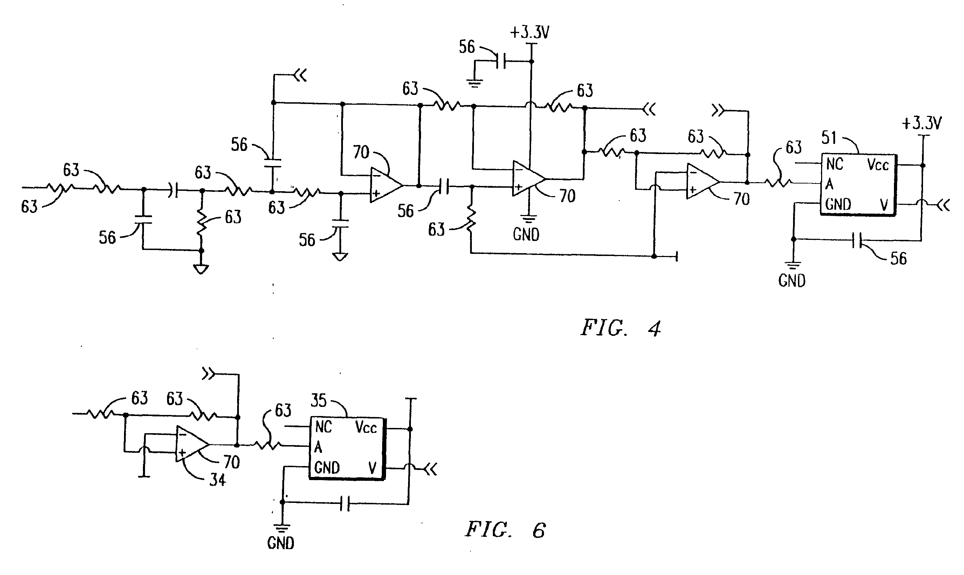

With reference to FIG. 4, a circuit diagram of a signal conditioning means is shown. The signal conditioning means, which is preferably at least one analog signal conditioning device **4,** cleans or conditions a 50/60Hz sine wave analog signal so as to remove any spurious signals or transient signals prior to its transmittal to the half cycle identifier **8**. If the sine wave has any noise or distortion of sufficient amplitude, this can, under certain circumstances, give rise to false zero cross detections. Thus, the inclusion of such analog signal conditioning device **4** is of importance.

To properly condition the sine wave signal, operational amplifiers **70** are utilized. An operational amplifier **70** is configured as an active, second order, low pass filter to remove or reduce harmonics and any transients or interfering signals that may be present. When utilizing such filter, however, group delay occurs wherein the group delay offsets, in time, the zero crossing of the filtered signal from the actual zero crossing point of the incoming AC sine wave. To remedy the delay, operational amplifiers **70** are provided to allow the phase change necessary to correct the zero crossing point accurately in time as required. The output of the operational amplifiers **70** is the fully conditioned 50/60 Hz sine wave signal that is connected to the A/D converter 11 of the digital signal processor **10** (see FIG. 1) for root-mean-square (RMS) value measurement. This signal is exactly half the supply rail which is necessary to enable measurement of both positive and negative half cycles. The A/D converter **11** performs the well-known 2s compliment math to enable same and requires the AC signal to deviate both positively and negatively with respect to the center or split rail voltage. The signal also enters the half cycle identifier **8**.

FIGS. 5 and 6 show an oscillogram and circuitry diagram, respectively, for a volts zero crossing point determining means. The volts zero crossing point determining means, which is preferably at least one volts zero crossing point detector **5** wherein the zero crossing point 21 is accurately determined. An operational amplifier **70** is configured as a comparator **34** with its reference at exactly half the supply voltage using half the supply rail. A comparator **34** operates at a very high gain and, as a result, switches within a few millivolts of the split rail voltage.

Additional conditioning of the zero cross signal is further performed by a Schmidt buffer **35**. Subsequent to the additional signal processing, a very accurate square wave **69** accurate to a few millivolts of the actual volts zero crossing point **21** of the sine wave is produced.

FIG. 7 shows a circuit diagram of a loss detecting means and phase rotation determination and rotating means. The loss detecting means, which is preferably at least one lost phase detection device **6,** and the phase rotation determination and rotating means, which is preferably at least one phase rotation device 7, work together so as to properly prepare the signal for transmittal into the logic device **9** and digital signal processor **10** when utilizing a three-phase electrical system. The lost phase detection device **6** circuitry includes operational amplifiers **70** configured as comparators **34** where each utilizes a high value of series resistors, comprising two 0.5 Meg Ohm resistors in series, which is necessary for achieving the required working voltage of the resistors **63,** and two diodes **53** connected in inverse parallel. The diodes **53** are centered around the volts zero crossing point **21** of the incoming sine wave **39** at approximately the voltage forward drop of the diodes **53,** which is in turn applied to the comparator **34** that further conditions the signal suitable for passing to the logic device **9** and digital signal processor **10,** resulting in the system being shut down in the absence of any of the signals.

In a three-phase electrical system, the phase rotation may be either A-B-C or A-C-B. To enable the digital signal processor **10** to properly function, the phase rotation must first be ascertained. The comparators **34** are used to detect the volts zero crossing point(s) **21** and report the point(s) **21** to the digital signal processor **10.** The digital signal processor **10,** in turn, makes the rotational timing through timing logic. Each of the operational amplifiers **70** act as a simple comparator **34** with the input signal, in each case provided by the inverse parallel pairs of diodes **53** in conjunction with the series resistors **63.**

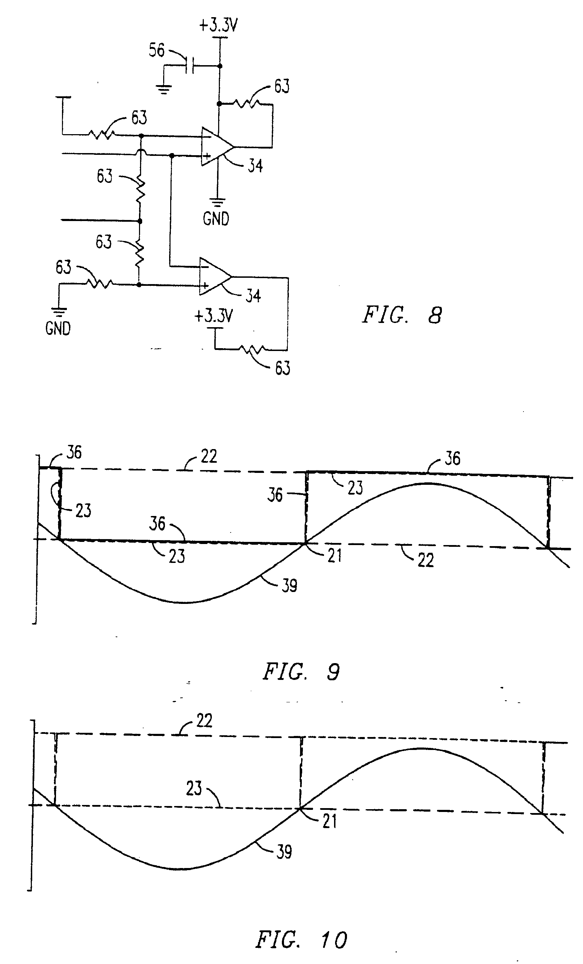

FIGS. 8, 9 and 10 show a circuit diagram and oscillograms, respectively, of a half cycle identifying means. The half cycle identifying means, which is preferably at least one half cycle identifier **8,** provides additional data to the logic device **9** and digital signal processor **10** by identifying whether the half cycle of the analog signal is positive or negative. This is of great importance to avoid a situation where if the IGBT/FET half cycle control transistors **54** and **58** and the IGBT/FET shunt control transistors **59, 60, 67** and **68** are simultaneously on, a short circuit would occur across the input power.

The operational amplifiers **70,** which are configured as window comparators **34,** have separate switching thresholds determined by at least one resistor **63.** As shown in FIG. 9, there are three signals, an absolute zero cross signal **36** and two co-incident signals wherein one co-incident signal has a positive half cycle **22** and one co-incident signal has a negative half cycle **23** of an incoming sine wave **39.** The design allows the window to be adjusted to provide, when required, the "dead band."

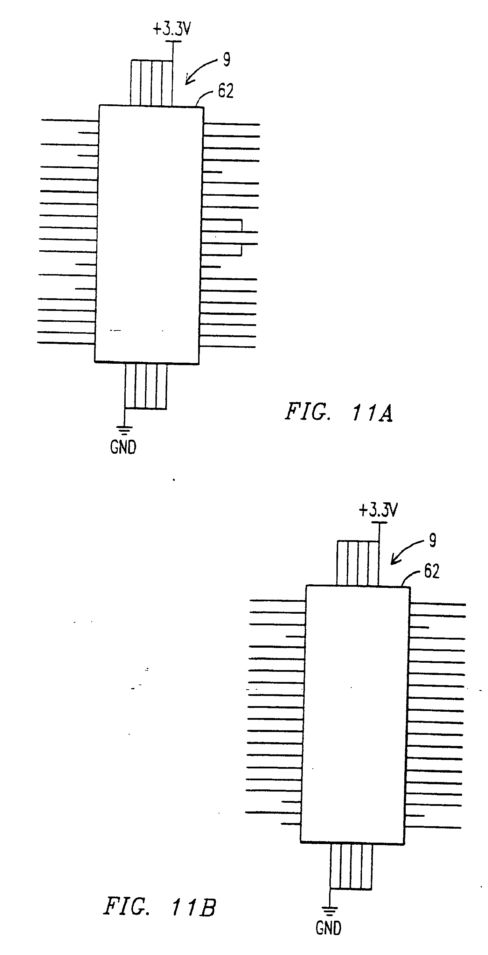

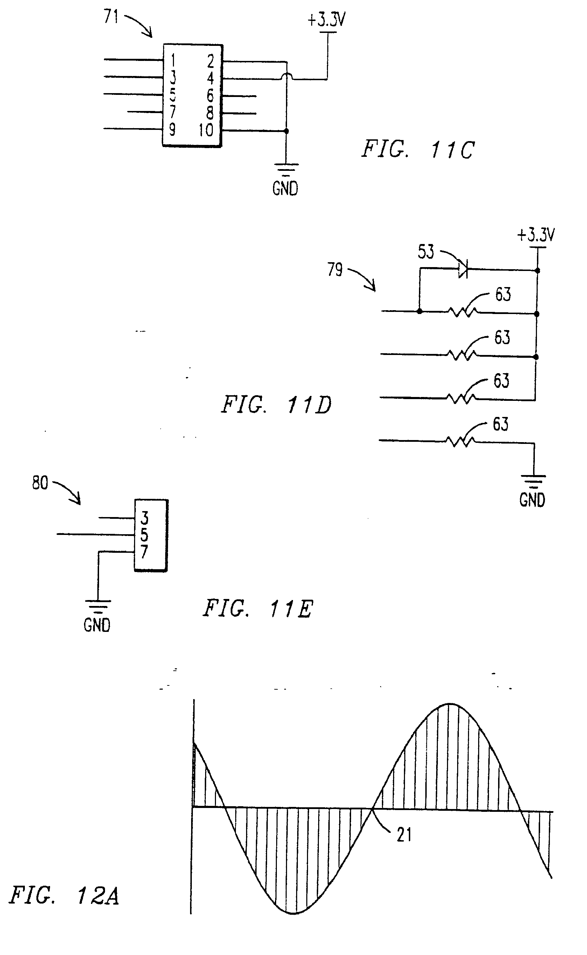

With reference to FIGS. 11A, 11B, 11C, 11D and 11E, circuit diagrams of the routing means are shown. The routing means, which is preferably at least one logic device **9,** works in real time, outside the digital signal processor **10,** to arbitrate between the on-times of the IGBT/FET half cycle control transistors **54** and **58** and the IGBT/FET shunt control transistors **59, 60, 67** and **68.**

The logic device **9** performs the routing function to assure that all signals are appropriate to the instantaneous requirement and polarity of the incoming sine wave **39** and performs the pulse width modulation function so as to assure the safe operation of the energy savings device and system **1,** regardless of the state of the digital signal processor **10,** presence of noise, interference or transients. The circuitry of the isolator 71, as shown in FIG. 11C, permits programming of the logic device **9.** The circuitry of the resistor support **79** of the logic device **9,** as shown in FIG. 11D, is necessary to operate the logic device **9.** As shown in FIG. 11E, the circuitry of the logic device connector **80** enables activation and deactivation of certain aspects of the logic device **9.**

Dealing with a resistive load is much less demanding than dealing with a reactive load, in particular, an inductively reactive load. Currently, pulse width modulation (PWM) is defined as modulation of a pulse carrier wherein the value of each instantaneous sample of a modulating wave produces a pulse of proportional duration by varying the leading, trailing, or both edges of a pulse and which is also known as pulse-duration modulation. However, for purposes of this invention and application, PWM is defined as the modulation of a pulse carrier wherein at least one slice is removed from an area under the curve of a modulating wave. When PWM is applied directly to the incoming power, the inductive component reacts when power is removed and attempts to keep the current going and will raise its self-generated voltage until the current finds a discharge path. This circumstance, without the shunt circuitry, would destroy the half cycle control transistors.

Therefore, the logic device **9** is a "supervisor" wherein it takes the appropriate action should the digital signal processor **10** "hang-up", if there is an over-current condition or if there is a phase loss. In any of these situations, the logic device **9** responds immediately, in real time, to safeguard the half cycle control transistors and shunt devices and the equipment connected to it.

Additionally, the logic device **9** mitigates the complex drive requirements of the IGBT/FET half cycle control transistors **54** and **58** and the IGBT/FET shunt control transistors **59, 60, 67** and **68** and, to an extent, unloads the digital signal processor **10** of this task. Since the logic device **9** controls this function, it may be performed in real time and, therefore, the timing control of the drive requirements can be held to much stricter limits than would be achieved by the digital signal processor **10.** The ability to respond in real time is important to the safe, reliable operation of the energy savings device and system **1** of the present invention.

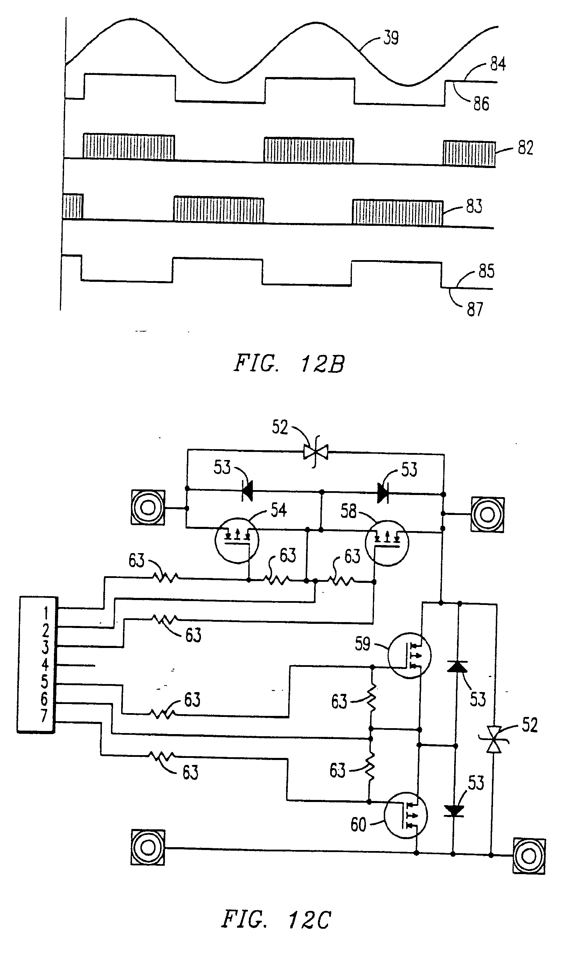

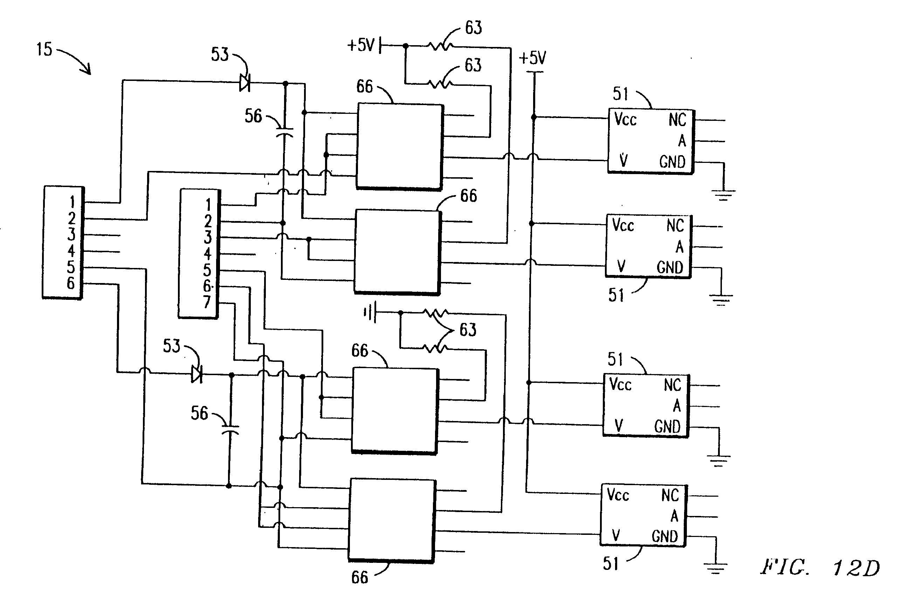

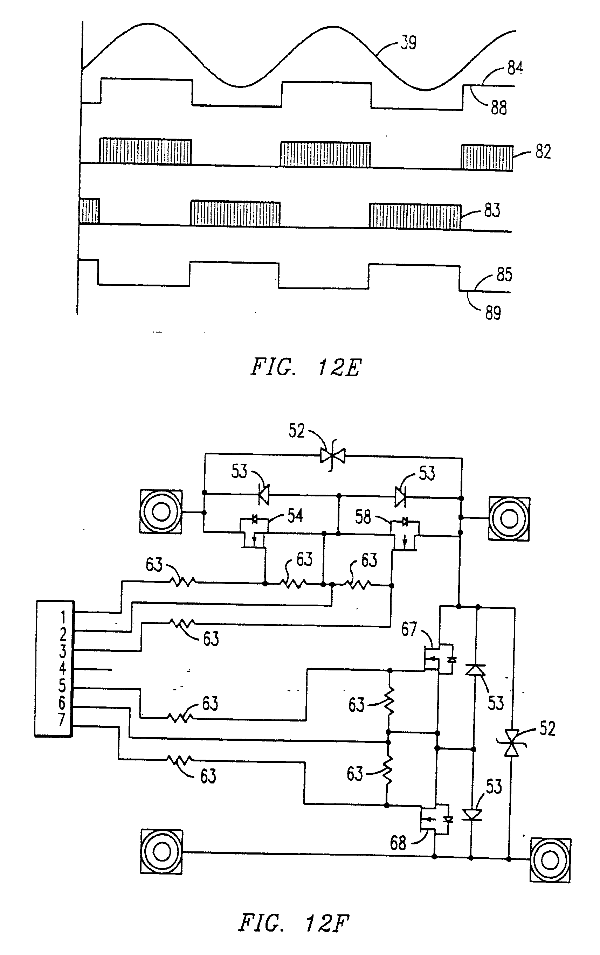

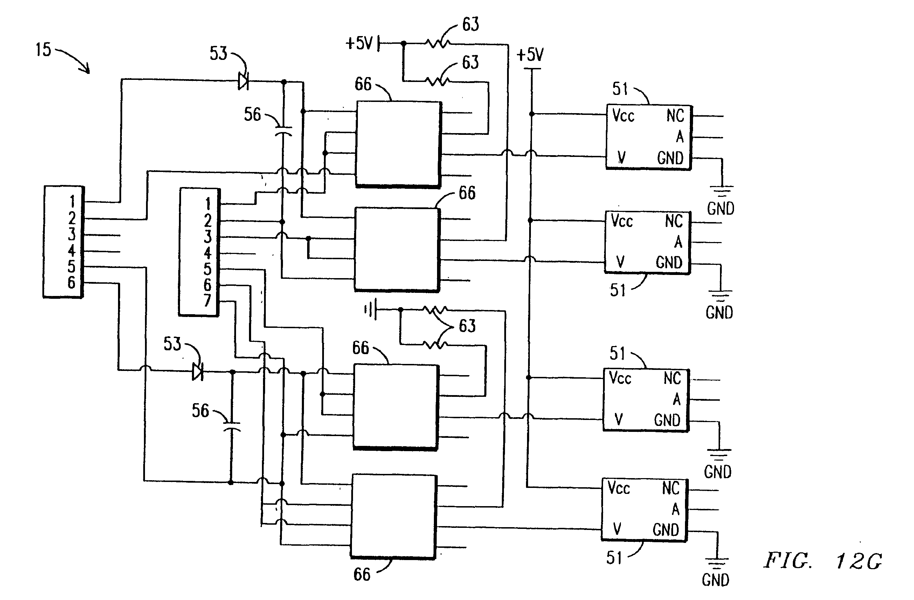

FIGS. 12A, 12B, 12C, 12D, 12E, 12F and 12G show oscillograms and circuit diagrams of a voltage reducing means. The voltage reducing means, which preferably includes at least one IGBT/FET drive control **15,** reduces the analog signals of the incoming sine wave **39,** which is the amount of energy inputted into the energy savings device and system **1,** by pulse width modulation wherein at least one slice is removed from an area under the curve of the modulating sine wave **39,** thereby reducing energy and without the attendant harmonics previously associated with such voltage control. This technique, as shown in FIG. 12A, works in conjunction with the inherent characteristics of the IGBT/FET devices that allows the on and off triggering point to be controlled. All of the potential energy is contained in each half cycle and, in the case of a complete half cycle, has the greatest area under the curve. If each half cycle is modulated on a mark space ratio of 90%, the area under the curve is reduced by 10% and, as a result, the energy is reduced proportionally as seen in FIG. 12A.

The original shape of the input sine wave is retained and, since modulation can be made high, possibly 10's of KHz, filtering of the output is possible due to the smaller size of the wound components becoming a practical proposition. The overall effect is realized when the root-mean-square value (RMS), which is the square root of the time average of the square of a quantity or, for a periodic quantity, the average is taken over one complete cycle and which is also referred to as the effective value, is correctly measured and the output voltage is seen to be reduced by a percentage similar to the mark space ratio employed. Reduced voltage results in reduced current, thereby resulting in reduced power consumed by an end user.

Since IGBT and FET devices are unipolar in nature, in the case of AC control, it is necessary to provide at least one IGBT/FET drive control 15 to control each half cycle. Furthermore, to avoid reverse biasing, steering diodes are used to route each half cycle to the appropriate device. Additionally, many IGBT and FET devices have a parasitic diode shunting main element wherein connecting two IGBT or FET devices in inverse parallel would result in having two of the parasitic diodes in inverse parallel, thereby rendering the arrangement inoperative as a controlling element.

The diodes 53 are connected across the positive half cycle transistor 54 and the negative half cycle control transistor 58 and works ideally for a purely resistive load or a current-leading reactive load. However, when driving a load with a current lagging power factor, when the current in an inductively reactive component is suddenly removed, as is the case when the modulation occurs, the collapsing magnetic field attempts to keep the current going, similar to an electronic fly-wheel, and produces an EMF that will rise in voltage until it finds a discharge path that will enable release of the energy. With this arrangement, this "back EMF" would cause active components of the half cycle control element to fail. To prevent this from occurring, additional IGBT/FET shunt control transistors 59, 60, 67 and 68 are placed in a shunt configuration.

During the positive half cycle, the positive half cycle control transistor 54 modulates and a diode 53 is active during the complete positive half cycle. The IGBT second shunt control transistor 60 is turned fully on and a diode 53 is active. Therefore, any opposite polarity voltages resulting from the back EMF of the load are automatically clamped.

During the negative half cycle, the other devices comprised in series and shunt networks are activated in a similar manner.

During the switching transitions, a spike may be present which may last for a very short period of time. The spike is clamped by the transorb devices 52, which are capable of absorbing large amounts of energy for a very short period of time and enables vary fast response time. The transorb devices 52 also clamp any mains bourn transient signals due to lightning strikes or other sources that could otherwise damage the active components of the half cycle transistors or shunt transistors. Further, while each half cycle transistor is pulse width modulating, the other half cycle transistor is turned fully on for the precise duration of the half cycle. The duties of these half cycle transistors reverse during the next half cycle. This process provides complete protection against the back EMF signals discussed above. This arrangement is necessary, especially near the zero crossing time when both shunt elements are in transition.

Each of the IGBT/FET half cycle control transistors 54 and 58 and the IGBT/FET shunt control transistors 59, 60, 67 and 68 have insulated gate characteristics that require the devices to be enhanced to enable them to turn on. This enhancement voltage is preferably 12 Volts in magnitude and is preferably supplied by a floating power supply, preferably one for each pair. This is only possible since the IGBT/FET devices are operated in the common emitter mode in the case of the IGBT's and in the common source mode in the case of the FET's; otherwise, four isolated power supplies would be required for each phase. Each of the pairs requires a separate drive signal that is provided by the isolated, optically-coupled drivers 66. These drivers 66 make use of the isolated supplies and serve to very rapidly turn on and turn-off each power device. These drivers 66 are active in both directions, which is necessary since the input capacitance of the power devices are high and have to be actively discharged rapidly at the turn-off point and charged rapidly at the turn-on point.

The problem with direct pulse width modulation is when driving an inductively reactive load as when the IGBT modulates off, there is a back EMF that needs to be clamped. Referring to FIG. 12B, an incoming sine wave 39 that is applied to the positive half cycle control transistor 54 and the negative half cycle control transistor 58 is shown. Normally, these half cycle control transistors 54 and 58 are in the "off" condition and need to be driven on. During the positive half cycle, the positive half cycle control transistor 54 is modulated and works in conjunction with a diode 53 to pass the modulated positive half cycle to a line output terminal. The IGBT second shunt control transistor 60 is on for the duration of the half cycle and operates in conjunction with a diode 53 so as to clamp the back EMF to ground. During the positive half cycle, the negative half cycle control transistor 58 is turned on fully and its on condition is supported by a diode 53. These diodes 53 perform the appropriate steering of the signals.

Due to modulation of the positive half cycle, a back EMF signal occurs. Since the negative half cycle control transistor 58 is on during this time, the negative back EMF is passed through a diode 53 to be clamped at the simultaneous AC positive half cycle voltage.

Although no modulation is applied to the IGBT first shunt control transistor 59 and the IGBT second shunt control transistor **60,** these transistors **59** and **60** work in conjunction with diodes **53** in a similar manner as set forth above.

As shown in FIG. 12B, which is an oscillogram of the voltage reducing means of the IGBT-based device, during the positive half cycle **22,** a drive signal is applied to the negative half cycle control transistor **85** and a drive signal is applied to the IGBT second shunt control transistor **87.** During the negative half cycle **23,** a drive signal is applied to the positive half cycle control transistor **84** and a drive signal is applied to the IGBT first shunt control transistor **86.** The positive half cycle drive signal **82** applied to the positive half cycle control transistor **54** and the negative half cycle drive signal **83** applied to the negative half cycle control transistor **58** are also shown.

Similarly, as shown in FIG. 12E, which is an oscillogram of the voltage reducing means of the FET-based device, during the positive half cycle **22,** a drive signal is applied to the negative half cycle control transistor **85** and a drive signal is applied to the FET second shunt control transistor **89.** During the negative half cycle **23,** a drive signal is applied to the positive half cycle control transistor **84** and a drive signal is applied to the FET first shunt control transistor **88.** The positive half cycle drive signal **82** applied to the positive half cycle control transistor **54** and the negative half cycle drive signal **83** applied to the negative half cycle control transistor **58** are also shown.

In summary, there are two clamping strategem used, the first for the positive half cycle and the second for the negative half cycle. During the positive half cycle, when the positive half cycle control transistor **54** is modulated, the negative half cycle control transistor **58** and the second shunt control transistor **60** are on. During the negative half cycle, when the negative half cycle control transistor **58** is modulated, the positive half cycle control transistor **54** and the IGBT first shunt control transistor **59** are on.

The hardware utilized in the IGBT-based and FET-based energy savings device and method 1 of the present invention is identical with the only difference being the IGBT/FET half cycle control transistors **54** and **58** and the IGBT/FET shunt control transistors **59, 60, 67** and **68.** The circuitry diagrams of the IGBT-based circuitry FIG. 12C and the IGBT based driver FIG. 12D and the FET-based circuitry FIG. 12E and the FET-based driver FIG. 12F are shown for comparison purposes.

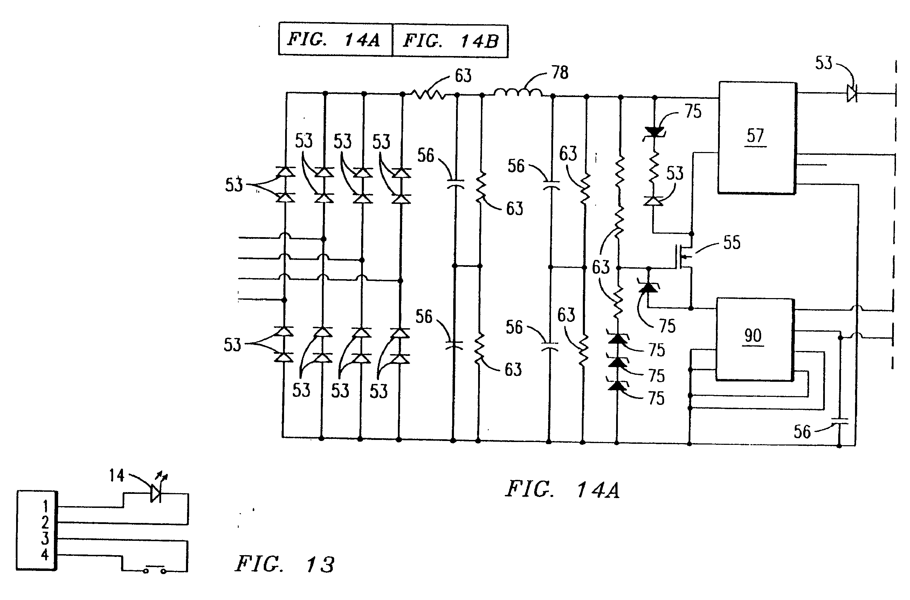

With reference to FIG. 13, a circuit diagram of a combined resetting means and indicator means is shown. The resetting means, which is preferably at least one reset switch **13,** and indicator means, which is preferably at least one light emitting diode **14,** work together so as to indicate when the IGBT/FET-based energy savings device and system 1 is not properly working and to permit a user to reset the device and system **1** as needed. Preferably, the light emitting diode 14 will indicate that the device and system **1** is working properly by flashing on/off. When in a fault condition, the light emitting diode **14** preferably changes to an uneven pattern that is immediately obvious and recognizable as a fault condition.

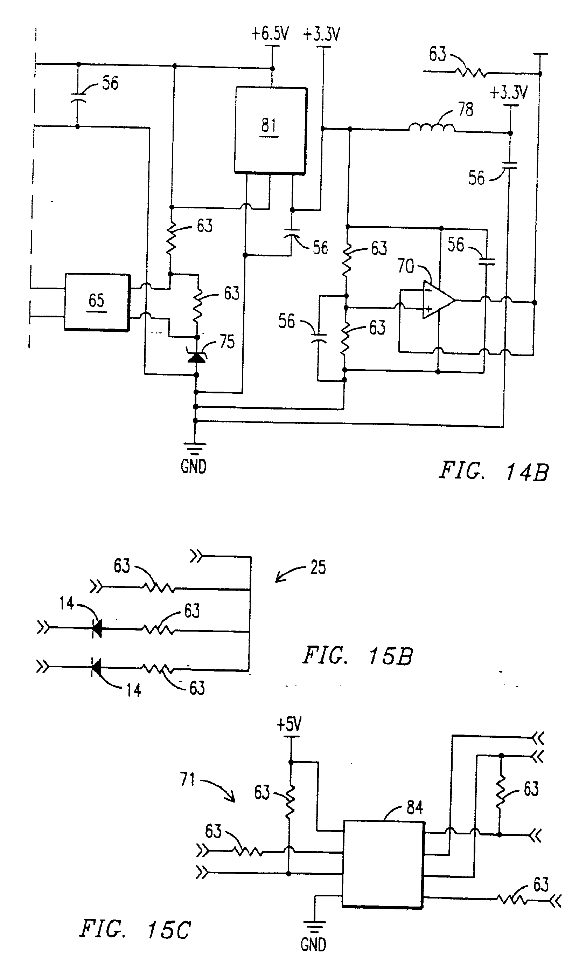

FIGS. 14A and 14B are a circuit diagram of a power supply unit **12** of a powering means. The powering means, which is preferably at least one power supply unit **12,** accepts a variety of inputs, including, but not limited to, single phase 80 $V_{rms}$ to 265 $V_{rms}$, bi-phase 80 $V_{rms}$ to 600 $V_{rms}$, three-phase 80 $V_{rms}$ to 600 $V_{rms}$ and 48 Hz to 62 Hz operation.

The power supply unit **12** is fully-isolated and double-regulated in design. At the input, a rectifier **72** composed of diodes **53** accepts single, bi- and three-phase power. The power is applied to a switching regulator **90** and integrated circuit **62** via a transformer **57.** In view of the large voltages existing across the DC terminals, the switching regulator **90** and integrated circuit **62** is supplemented by a FET transistor **73** employed in a StackFET configuration in order to raise its working voltage. The secondary of transformer **57** has a diode **53** and a reservoir capacitor **56.** The DC voltage across capacitor **56** is passed via the network resistors **63** and a Zener diode **75** to an optical isolator **65** and finally to the feedback terminals. Use of the optical isolator **65** guarantees galvanic isolation between the input and the supply output (6.4V DC). Finally, the output of the linear voltage regulators **81** (3.3 VA DC) is passed to a operational amplifier **70,** which is configured as a unity gain buffer with two resistors **63** that set the split rail voltage. The main neutral is connected to this split rail point and also a zero Ohm resistor. An inductor **78** isolates the supply rail digital (+3.3V) from the analog (3.3 VA) and reduce noise.

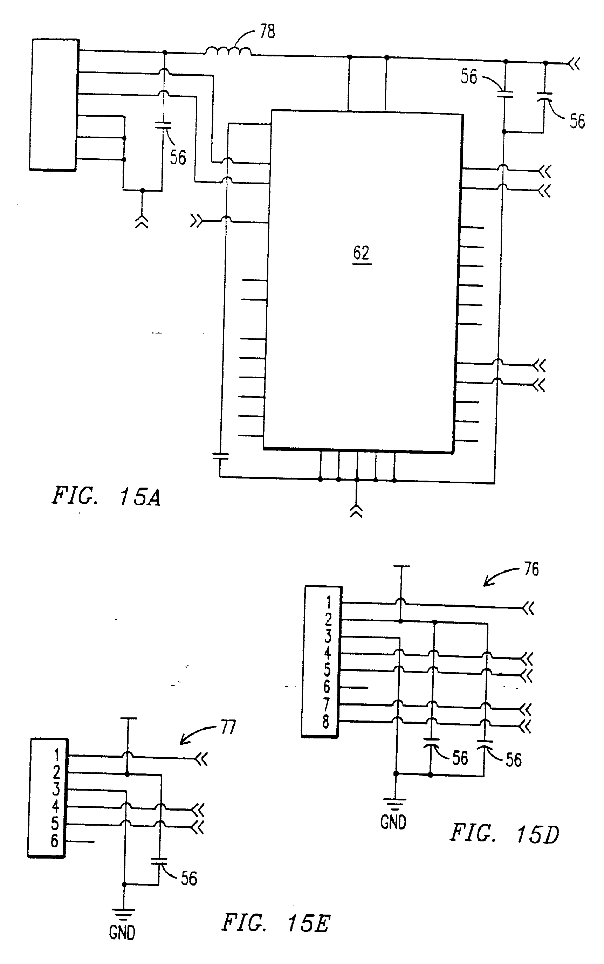

Next, FIGS. 15A, 15B, 15C, 15D and 15E show the circuitry of a communication means. The communication means, which is preferably at least one USB communications interface **25,** permits a user to monitor and set the parameters of the energy savings device and system **1** of the present invention as desired.

The circuitry of a USB communications interface **25** is shown in FIG. 15B, an isolator block **71** utilized in isolating the USB communications interface **25** from the digital signal processor **10** is shown in FIG. 15C and first and second connectors **76** and **77** for connecting the communications means to the digital signal processor **10** are shown in FIGS. 15D and 15E.

Since the main printed circuit board is not isolated from neutral, it is necessary to galvanically isolate the USB communications interface **25.** Use is made of the built-in serial communications feature of the digital signal processor **10** to serially communicate with the communication means **46.** Signals, on the user side of the isolation barrier, are applied to an integrated circuit **62,** which is a device that takes serial data and translates it to USB data for direct connection to a computing device **16** via a host USB port **74.** The host USB 5V power is used to power the communication means **46** and voids the necessity of providing isolated power from the unit. Preferably, there are two activity light emitting diodes **14,** that indicate activity on the TX (transmit) and RX (receive) channels. Communications preferably operates at 9600 Baud, which is adequate in view of the small amount of data passed.

Although the inclusion of a communications means is not necessary in the performance of the energy savings device and system **1,** it is a feature that permits easier use of the device and system **1.**

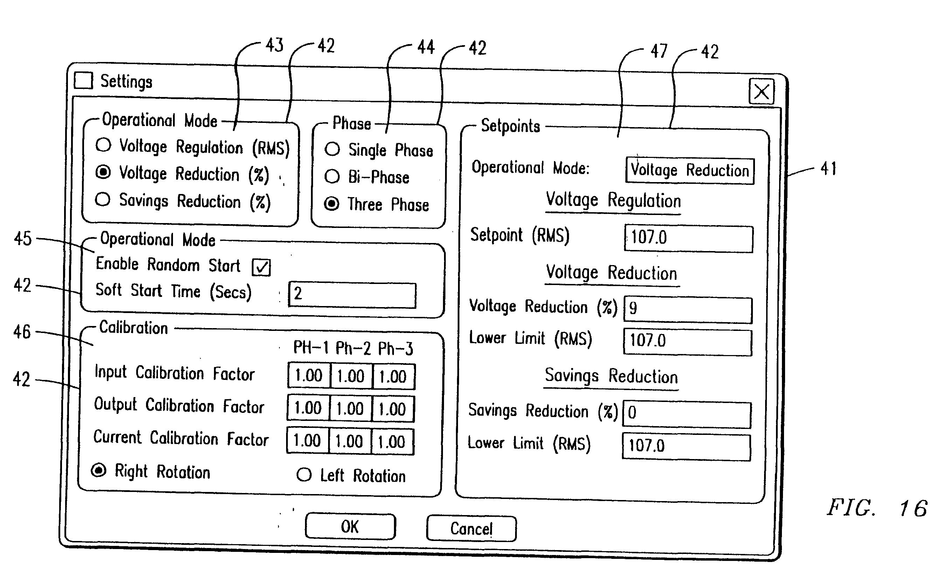

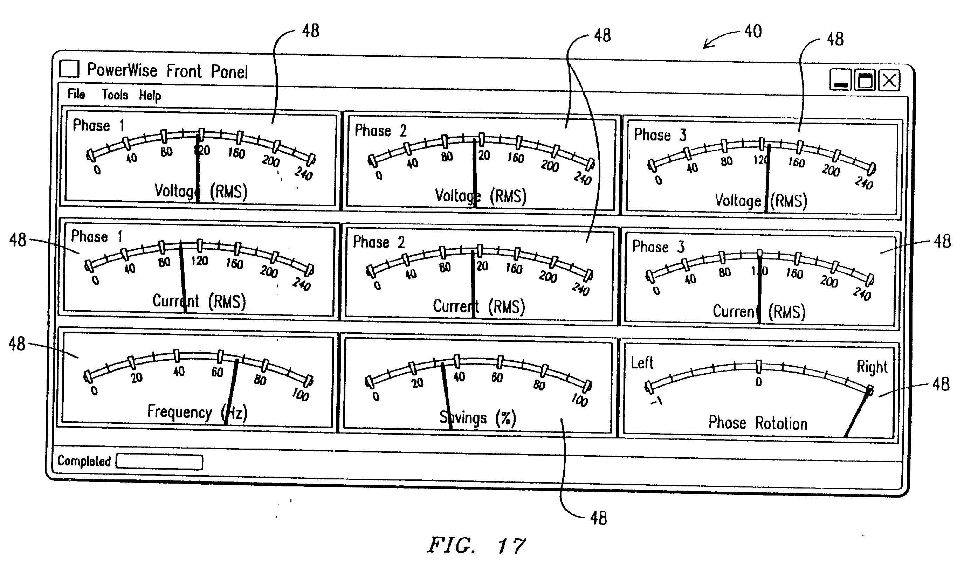

Finally, with reference to FIGS. 16 and 17, screen shots of a windows interface **40** of the present invention are shown. The windows interface **40** is displayed on the computing device **16** and permits a user to monitor and configure the energy savings device and system **1** as desired. A main monitoring screen **41** having a plurality of fields **42** in which an end user may adjust the energy savings device and system **1** are provided. For example, the fields **42** may include an operational mode field **43,** a phase field **44,** a startup field 45, a calibration field **46** and a setpoints field **47.**

In the operational field **43,** a user may select the manner in which he/she/it desires to conserve energy. The manners include voltage reduction percentage wherein the output Volts is adjusted by a fixed percentage, savings reduction percentage wherein the output Volts is aimed at achieving a savings percentage and voltage regulation wherein the root mean squared Volts output is a pre-set value.

The phase field **44** permits a user to select the phase type used in connection with the energy savings device and system **1,** i.e., single phase, bi-phase or three phase.

The startup field **45** permits a user to configure the system and device 1 to randomly start and/or to have a delayed or "soft start" wherein the user input the delay time in seconds in which the system and device will start.

The calibration field **46** permits a user to input the precise calibrations desired and/or to rotate the phases.

The setpoints field **47** displays the settings selected by the user and shows the amount of energy saved by utilizing the energy savings device and system **1** as voltage regulation, voltage reduction percentage or power savings reduction percentage. With respect to percentage voltage reduction, the lower limit RMS is set below the incoming voltage passed therethrough to permit the incoming voltage to be passed through when it is less than or equal to the lower limit voltage. With respect to the percentage savings reduction, the lower limit RMS is set below the incoming voltage passed therethrough.

Indicators **48** are provided on the windows interface **40** display operating current, operating voltage, line frequency, calculated power savings and phase rotation.

A real time clock **49** may be incorporated into the windows interface **40** to allow programming of additional voltage reduction for a predetermined time and a predetermined operational time, *e.g.,* for seasons, days of the week, hours of the day, for a predetermined operational time. In addition, a user may program the energy savings device and system **1** to operate during various times of the day. The real time clock **49** is set through a communications port or fixed to allow the selection of defined seasonal dates and time when, through experience, are known to exhibit power grid overload. During these times, the system allows further reduction of the regulated AC voltage, thereby reducing the load on the grid. Multiple time can be defined each with its own additional percentage reduction or voltage drop.

The digital electricity meter **50** provides a means to log statistical data on power usage, power factor and surges. The digital electricity meter **50** also provides the ability to include capacitors for power factor correction, operates on single, bi and three-phase systems and operates on all world wide voltages. It may be used remotely or locally to disable or enable the user's power supply at will by the provider. In addition, the digital electricity meter 50 may detect when the energy savings device and system **1** has been bridged by an end user attempting to avoid paying for energy consumption wherein the provider is alerted to such abuse. Finally, use of the real time clock **49** permits a user and/or provider to reduce the consumption of power at selected times of a day or for a selected time period, thereby relieving and/or eliminating brown-out conditions.

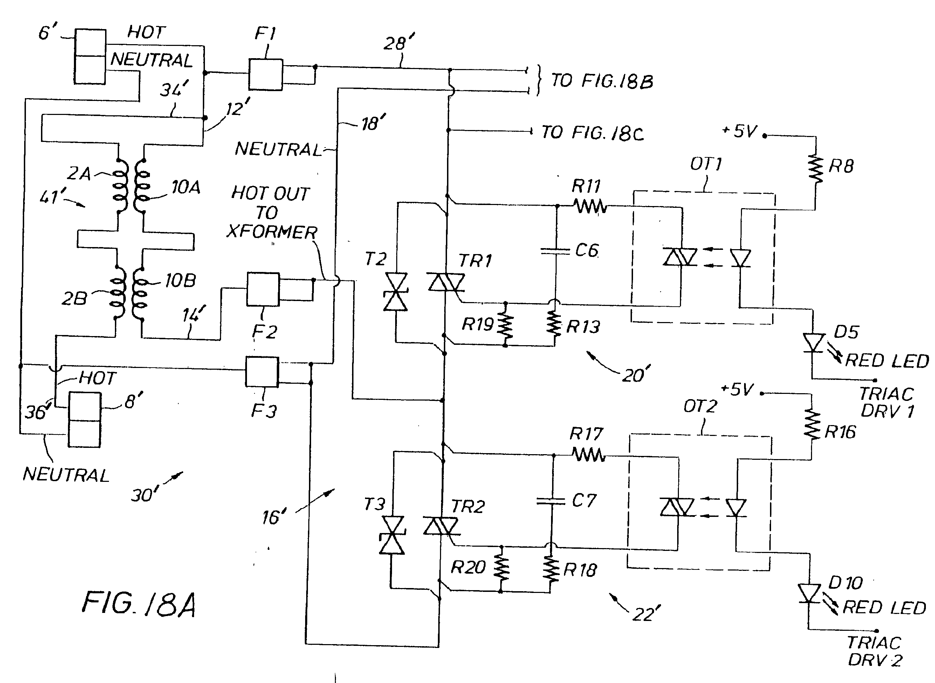

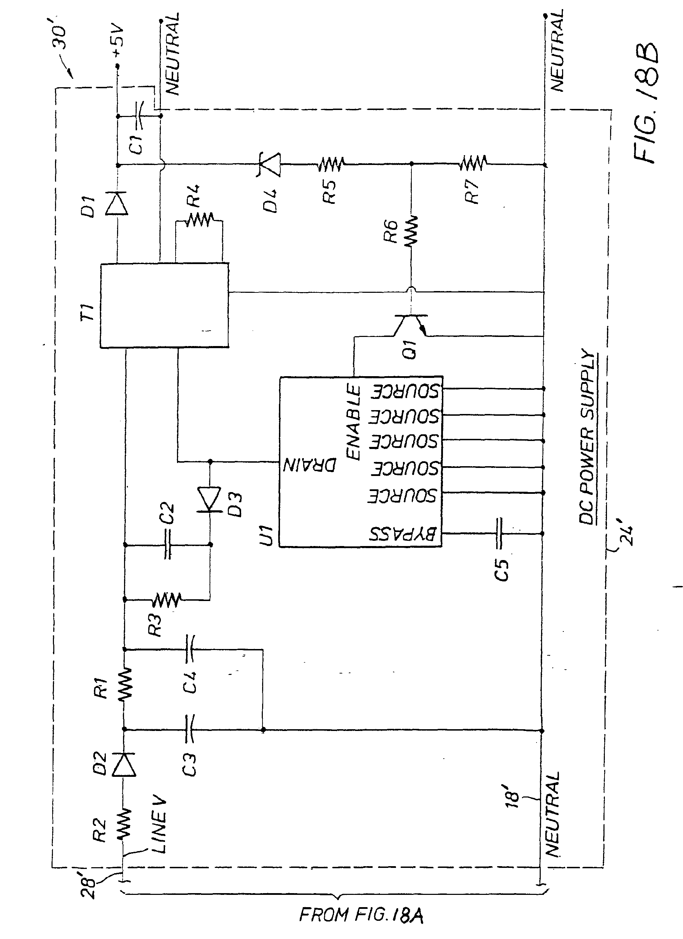

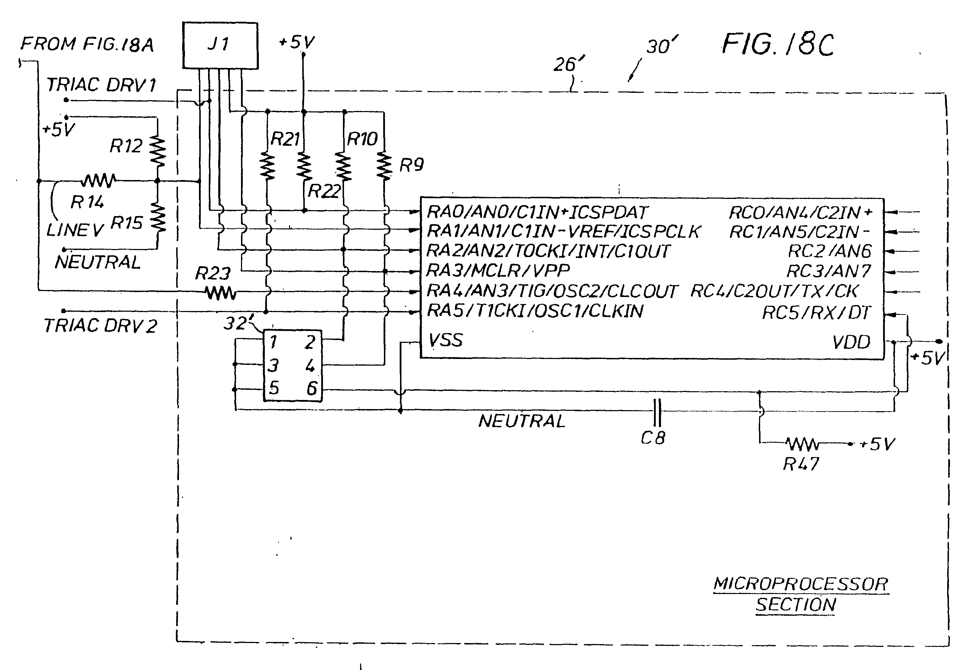

FIGS. 18A-18C taken together show a first embodiment of a voltage booster apparatus **30'** configured for 220/230 Voltage root mean square (Vrms). The voltage booster apparatus **30'** may also be configured for 120/127 Vrms. FIG. 18A shows transformer **41'** and switch **16'**. Switch **16'** comprises first relay **20'** and second relay **22'**. FIG. 18B shows power supply **24'**. FIG. 18C shows microprocessor **26'**. Turning to FIG. 18A, secondary windings **2A** and **2B** of transformer **41'** are in series between the input line hot terminal **6'** and the output line hot terminal **8'**. Hot input line **34'** to hot output line **36'** passes through the transformer secondary windings **2A** and **2B** at all times, and is not switched. To configure for 120/127 Vrms, then the secondary windings **2A** and **2B** would be in parallel. Alternatively, the transformer may be a single voltage type specifically for 230 V, 120 V, or any other voltage range.

The transformer primary windings **10A** and **10B** have first end or first line **12'** connected to hot input terminal **6'** and second end or second line **14'** connected through connector **F2** with electronic switch **16'**. Switch **16'** allows transformer second line **14'** to either (1) connect with first line **12'** of the transformer primary windings **10A, 10B,** thereby short-circuiting the transformer **41'**, or (2) connect with neutral line **18'**. Connectors (**F1, F2, F3**) are Faston type connectors. The connectors (**F1, F2, F3**) allow for the removably plugging in of different current rated transformers allowing for greater or lesser loads. Other types of connectors are also contemplated.

When the transformer primary windings second line **14'** is switched to neutral, the secondary voltage adds to the mains input voltage, thereby providing boosted or increased output voltage at hot output terminal **8'**. An electrical load may be connected at hot output terminal **8',** such as a residential, commercial or industrial load. The winding voltage is phased to be additive to the incoming AC line voltage, thereby providing boosted voltage when needed. When the microprocessor **26'** switches to increased or boosted voltage, the boosted voltage may be maintained at the incoming Vrms multiplied by the percentage ratio of the transformer turns ratio.

When switch **16'** is switched to the other condition, state, or position, removing the second line **14'** connection from neutral and connecting it with first line **12',** the transformer primary windings **10A** and **10B** are short circuited. By creating a short circuit in the non-boosted condition or state, the transformer **41'** is disconnected and does not consume any power. Also, since the primary **10A** and **10B** is shorted out, and the secondary **2A** and **2B** is permanently connected between input terminal **6'** and output terminal **8',** there will be substantially no reactive component of current in the secondary side and therefore substantially no inductively reactive losses are incurred during non-boost operation. The only impediments to the passage of the AC power from hot input **6'** to hot output **8'** will be the very small ohmic resistance of the copper or other windings of the secondary windings **2A** and **2B.**

The switching is advantageously performed on the transformer primary side (**10A, 10B**). While switching could take place on the secondary side (**2A, 2B**) of the transformer **41',** disadvantageous high currents would be present. Since the transformer **41' may** have a ratio of ten (10) to one (1), only one-tenth of the current would need be switched in the primary side (**10A, 108**) of the transformer **41'.** Other transformer ratios are also contemplated. The transformer ratio is the number of turns in the secondary (**2A, 2B**) to the number of turns in the primary (**10A, 10B**). In all embodiments, this technique of switching on the primary side allows for the use of smaller more reliable switches for lower current, such as relay devices **20'** and **22',** as compared to much more expensive devices if the switching were to take place at the secondary side (**2A, 2B**) of the transformer **41'.** Also, the switching on the primary side advantageously provides for no interruption of power during the switching period. Although two relay devices **20'** and **22'** are shown, it is also contemplated that there may be more than two of the devices (**20', 22'**).

Power supply **24'** (FIG. 18B) may provide power to the switching network **16'** and microprocessor **26'.** A small inexpensive five (5) volt DC power supply may be employed to power the switch **16'** and/or microprocessor **26',** although other power supplies and voltages are also contemplated, including alternating current. Devices **20'** and **22'** (FIG. 18A) may each consist of an optically coupled driver in communication with a small TRIAC device, thereby forming two solid-state AC relays. Opto-electronically (opto) isolated Triac drivers using opto isolated TRIACS (**OT1, OT2**) are contemplated. Other types of relays are contemplated. It is also contemplated that the voltage may be controlled through the use of other power control devices, including TRIACs, SCRs, IGBTs, and/or MOSFETs.

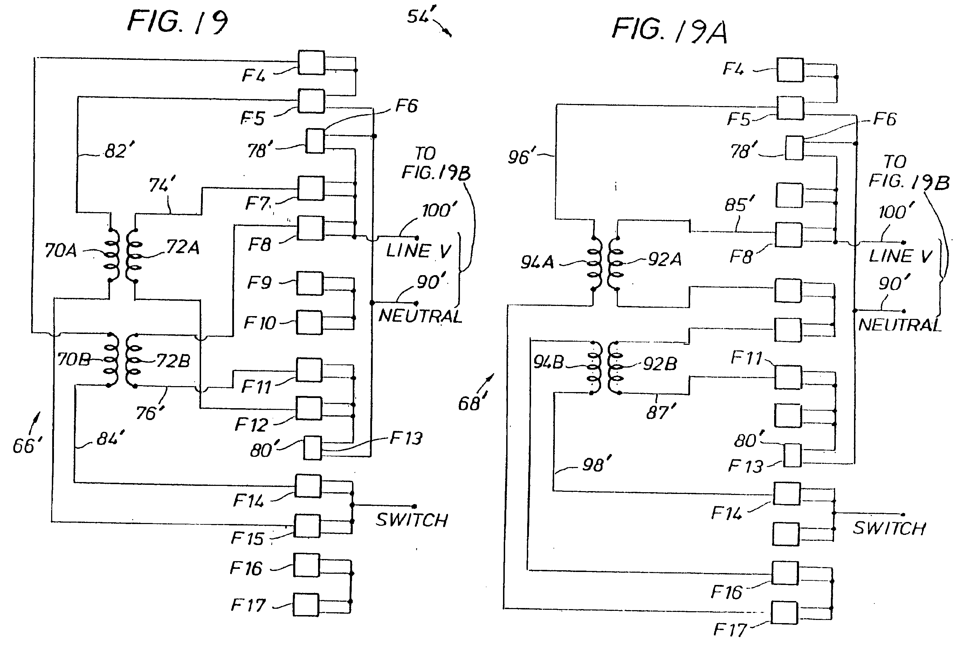

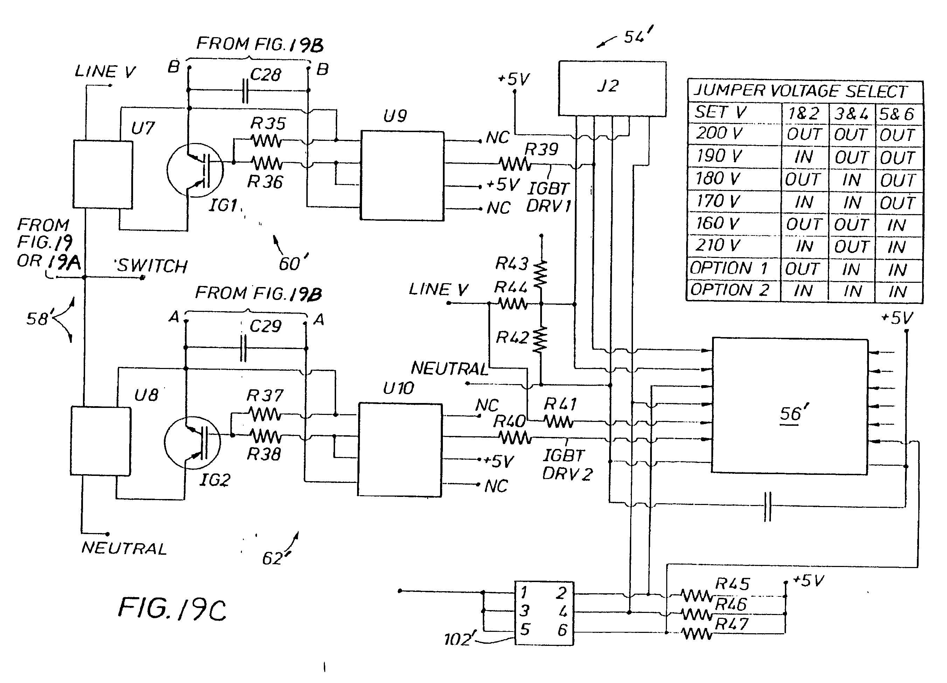

Microprocessor **26'** (FIG. 18C) measures the AC incoming line voltage, such as in lines **34'** or **28',** and decides the voltage level at which the increased voltage should be employed. Other types of processors are also contemplated. Three small jumper blocks or 3 x 2 header **32'** may allow the selection of the six (6) voltages as shown below in Table 1 and on FIG. 19C:

TABLE 1: JUMPER VOLTAGE SELECTION

| SET VOLTAGE | CONTACTS 1 & 2 | CONTACTS 3 & 4 | CONTACTS 5 & 6 |
|---|---|---|---|
| 200 Volts | OUT | OUT | OUT |
| 190 Volts | IN | OUT | OUT |
| 180 Volts | OUT | IN | OUT |
| 170 Volts | IN | IN | OUT |
| 160 Volts | OUT | OUT | IN |
| 210 Volts | IN | OUT | IN |
| OPTION 1 | OUT | IN | IN |
| OPTION 2 | IN | IN | IN |

Other predetermined voltage settings are also contemplated. Other numbers of jumper blocks or headers **32'** are also contemplated. The microprocessor **26'** operates and controls the relay devices **20'** and **22'** according to the selected voltage.

Microprocessor **26'** (FIG. 18C) measures the AC incoming line voltage. The microprocessor **26'** utilizes detection of the zero voltage crossing point of the incoming AC mains voltage. This zero cross detection is used to assure correct timing of the switching of the solid-state relays **20'** and **22'.** Zero cross timing eliminates the possibility of both relays **20'** and **22'** being on at the same time. FIGS. 5 and 6 propose an oscillogram and circuitry diagram, respectively, of a volts zero crossing point determining means that is contemplated. Other types of volts zero crossing point determining means are also contemplated. Hysteresis may be employed to eliminate any erratic switching around the threshold point set by the jumpers **32'.**

In FIGS. 18A-18C, components **R1** to **R23** are resistors, components **C1** to **C8** are capacitors, components **D1** to **D3** are diodes, component **D4** is a Zener diode, components **D5** and **D10** are light emitting diodes, component **T1** is a transformer, components **T2** and **T3** are transorb devices, component **Q1** is an NPN transistor, component **U1** is a switching regulator, components **TR1** and **TR2** are TRIACs, components **OT1** and **OT2** are opto isolated TRIACS, and component **J1** is a jumper block or 1 x 5 header.

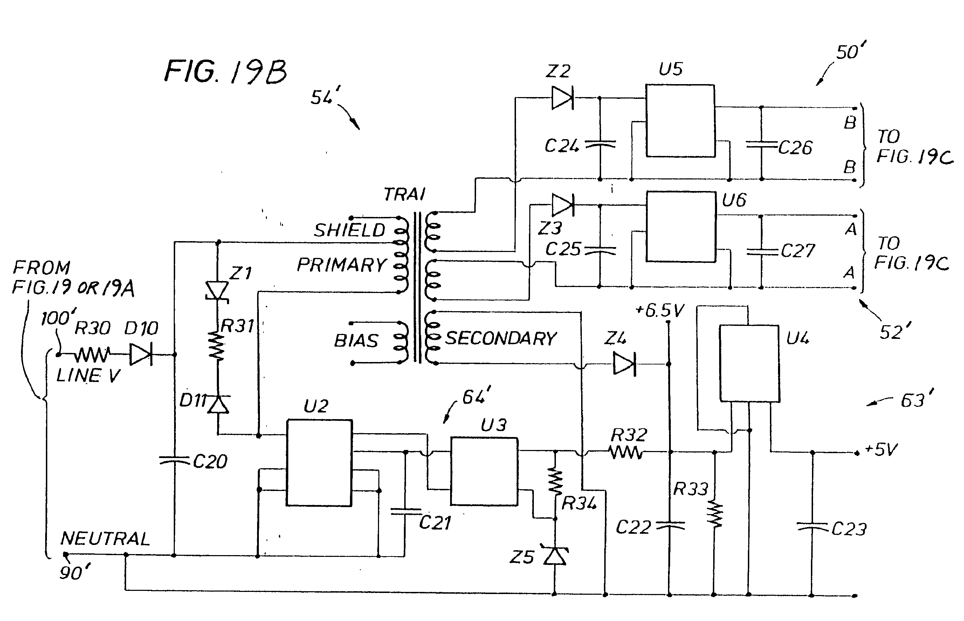

FIGS. 19-19C taken together show a second embodiment of a voltage booster apparatus **54'**. FIG. 19 shows exemplary 120 Volt transformer **66'**. FIG. 2A shows exemplary 230 Volt transformer **68'**. The wiring arrangements are different in FIGS. 19 and 19A. The windings for the 120 Volt transformer **66'** (FIG. 19) are in parallel, and the windings for the 230 Volt transformer **68'** (FIG. 19A) are in series. The same transformer **66', 68'** may be used for 120 Volt and for 230 Volt by configuring the wiring arrangements as shown: parallel for 120 Volts and series for 230 Volts. However, different **66', 68'** transformers may be used as well. The transformer may be a single voltage type specifically for 230 V, 120 V, or any other voltage range. Other transformers with different current ratings are also contemplated. Only one such transformer **66', 68'** would be connected with the system at a time. FIG. 19B shows two isolated DC power supplies (**50', 52'**), power supply **63'**, and power supply regulation circuitry **64'**. FIG. 19C shows microprocessor **56'** and IGBT switch device **58'**. Switch **58'** comprises first diode bridge circuit **U7,** first IGBT circuit **60',** second diode bridge circuit **U8,** and second IGBT circuit **62'**.

Turning to FIG. 19, secondary windings **72A** and **72B** of 120 Volt transformer **66'** are in parallel between the input line hot terminal **78'** and the output line hot terminal **80'**. Hot input line **74'** to hot output line **76'** passes through the transformer secondary windings **72A** and **72B** at all times, and is not switched. The transformer **66'** primary windings **70A** and **70B** have first end or first line **82'** connected to hot input terminal **78'** through connector **F5,** and second end or second line **84'** connected through connector **F14** with electronic switch **58'**. Switch **58'** allows transformer **66'** second line **84'** to either (1) connect with first line **82'** of the transformer **66'** primary windings **70A, 70B,** thereby short-circuiting the transformer **66',** or (2) connect with neutral line **90'**. Connectors **F4** through **F17** are Faston type connectors. The connectors (**F1** to **F17**) allow for the removably plugging in or connecting of different rated transformers (**66', 68'**), such as 120V and 230V. Other types of connectors are also contemplated.

In FIG. 19A, the 230V transformer **68',** like the 120V transformer **66',** may be removably plugged or unplugged into the same connectors (**F1** to **F17**). However, the wiring arrangement for transformer **68'** is different. Other arrangements of wiring and connection are also contemplated. The transformer **68'** secondary windings **92A** and **92B** are in series between the input line hot terminal **78'** and the output line hot terminal **80'**. Hot input line **85'** passes through connector **F8** to terminal **78'**. Hot output line **87'** passed through connector **F11** to terminal **80'**. Hot input line **85'** to hot output line **87'** passes through the transformer secondary windings **92A** and **92B** at all times, and is not switched. The transformer **68'** primary windings **94A** and **94B** have first end or first line **96'** connected to hot input terminal **78'** through connector **F5**, and second end or second line **98'** connected through connector **F14** with electronic switch **58'**. Switch **58'** allows transformer **68'** second line **98'** to either (1) connect with first line **96'** of the transformer **68'** primary windings **94A**, **94B,** thereby short-circuiting the transformer **68',** or (2) connect with neutral line **90'**.

As can now be understood, the same transformer may be used for 120 V and 230 V, with the connections shown in FIGS. 19-19A configuring the transformer for 120 V (FIG. 19) or 230 V (FIG. 19A) as desired. When the transformer primary windings second line **84'**, **98'** is switched to neutral, the secondary voltage adds to the mains input voltage, thereby providing boosted output voltage at hot output terminal **80'**. An electric load may be connected with output terminal **80'**. The winding voltage is phased to be additive to the incoming AC line voltage, thereby providing boosted voltage when needed.

When switch **58'** is switched to the other state or condition, removing the primary windings second line **84'**, **98'** connection from neutral and connecting it with respective first line **82'**, **96'**, the transformer primary windings (**70A**, **70B**) or (**94A**, **94B**) are short circuited. By creating a short circuit in the non-boosted position, the transformer is disconnected and does not consume any power. Also, since the primary is shorted out, and the secondary is permanently connected between hot input terminal **78'** and hot output terminal **80'**, there will be substantially no reactive component of the current on the secondary windings side and therefore substantially no inductively reactive losses during non-boost operation. The only impediments to the passage of the AC power from input **78'** to output **80'** will be the very small ohmic resistance of the copper or other windings of the secondary windings. As with the first embodiment, the switching is advantageously performed on the transformer primary side, which allows for switching with less current. Also, there is substantially no interruption of power during the switching period.

Turning to FIG. 19B, three independent power supplies (**50', 52', 63'**) may provide power to switching network **58'** and/or microprocessor **56'**. First power supply **50'** provides power to first IGBT circuit **60',** and second power supply **52'** provides power to second IGBT circuit **62'**. It is contemplated that the arrangement could be reversed. Third power supply **63'** may provide power for microprocessor **56'**, LEDs, and Optos. Other arrangements are also contemplated. First and second power supplies (**50', 52'**) may each provide twelve (12) volt DC power, and third power supply **63'** may provide five (5) volt DC power, although other power supplies and voltages are also contemplated, including alternating current. It is contemplated that there may be only one power supply, or more than three power supplies.

In FIG. 19C, first diode bridge circuit **U7** is configured with first IGBT circuit **60'** comprising first IGBT device **IG1** and first optically isolated IGBT/MOSFET driver **U9**. Second diode bridge circuit **U8** is configured with second IGBT circuit **62'** comprising second IGBT device **IG2** and second optically isolated IGBT/MOSFET driver **U10**. Diode bridge circuits **U7**, **U8** are used to steer the current positive and negative half cycles to arrive at a condition known as unidirectional half cycles. This enables the use of a single IGBT device **IG1** and **IG2** since the IGBT is a unidirectional device. MOSFET devices are also contemplated.

Switch **58'** functions like a single pole, double throw (SPDT) switch, sometimes referred to as a "changeover switch." When the respective IGBT device **IG1** or **IG2** is in an OFF condition, state, or position, then no AC current flows through the respective diode bridge **U7**, **U8**. When the respective IGBT device **IG1** or **IG2** is in an ON condition, state, or position, then AC current flows through the respective diode bridge **U7**, **U8**. Microprocessor **56'** measures the AC incoming line voltage, such as in line **100'**, and decides the voltage level at which the increased voltage should be employed. Three small jumper blocks or 3 x 2 header **102'** may allow the selection of the six (6) voltages as shown in Table 1 above and in FIG. 19C. Other predetermined voltage settings are also contemplated. Other numbers of jumper blocks or header **102'** are also contemplated. The microprocessor **56'** operates and controls the IGBT switch device **58'** to maintain the selected voltage.

The microprocessor **56'** may utilize detection of the zero voltage crossing point of the incoming AC mains voltage. This zero cross detection is used to assure correct timing of the switching of the IGBT devices **IG1** and **IG2**. Zero cross timing eliminates the possibility of both devices **IG1** and **IG2** being on at the same time. FIGS. 5 and 6 propose an oscillogram and circuitry diagram, respectively, of a volts zero crossing point determining means that is contemplated. Other types of volts zero crossing point determining means are also contemplated. Hysteresis may be employed to eliminate any erratic switching around the threshold point set by the jumpers **102'**.

In FIGS. 19-19C, components **R30** to **R47** are resistors, components **C20** to **C29** are capacitors, components **D10** and **D11** are diodes, component **Z1** is a transorb, components **Z2** to **Z4** may be (Schottky type) diodes, component **Z5** is a Zener diode, components **IG1** and **IG2** are IGBT transistors, component **TRA1** is a transformer, component **U2** is a switching regulator, component **U3** is an Opto isolator, components **U4** to **U6** are linear regulators, components **U7** and **U8** are diode bridge circuits or bridge rectifiers, component **U9** and **U10** are optically isolated IGBT/MOSFET drivers, and component **J2** is a 1 x 5 header.

As can now be understood, all switching may be performed at substantially less current on the primary side, such as primary side (**10A, 10B**) of the transformer **41'**, than on the secondary side, such as secondary side (**2A, 2B**) of transformer **41'**. Since the secondary windings are permanently connected, and the boost switching is performed on the primary side, there will be substantially no interruption of electricity during the switching period. This cannot be achieved when switching is performed on the secondary side. Different embodiments of electronic switches (**16', 58'**) are employed to short circuit the transformer primary when it is not in use, thereby eliminating the reactive component of the current from the secondary winding side. The transformer is only active during the voltage boost period. The amount of boost or increase may be selected by the transformer ratio. Transformers with different ratios and/or current ratings may be removably connected with the system. The apparatus may be used for universal operation for AC 120 Volts to 250 Volts. The apparatus size may be relatively small. There may be very small thermal dissipation. The apparatus may be cost effective and reliable. The apparatus may be used to supply increased voltage for electric loads, including residential, industrial or commercial.

Although two switching network embodiments are shown in FIGS. 18A-19C, other embodiments are contemplated, including, but not limited to, the switching performed with (1) a diode bridge in conjunction with an IGBT, (2) a diode bridge in conjunction with a power MOSFET, (3) a diode bridge in conjunction with a mechanical switch, relay, contactor or any other type of mechanical switch, (4) a diode bridge in conjunction with an SCR/Thyristor or a TRIAC, (5) TRIAC, (6) SCR/Thyristor devices arranged in an inverse parallel arrangement, or (7) a mechanical switch, relay, contactor or any other type of mechanical switch. The switches may be used to provide a first state, condition, or position short circuiting the primary windings, and a second state, condition, or position for adding the transformer secondary voltage with the mains input voltage. In all embodiments, other transformer primary windings taps are contemplated to provide different boost levels at a variety of threshold voltages. The taps may allow a certain number of turns of the transformer primary winding to be selected, providing a transformer with a variable turns ratio. For all embodiments, there may be multiple taps on the primary windings selected by the microprocessor for providing differing boost levels at differing input voltage levels.

Managing Electrical Power Usage

The IGBT/FET-based device **1** shown in FIGS. 1-17 and the voltage booster system **30'** shown in FIG. 18A-19C may work together to manage electrical power usage. During a first predetermined time period, such as when blackouts are not anticipated, the DSP **10** controls the IGBT/FET-based device **1** shown in FIG. 1 to supply a predetermined voltage that is less than the AC incoming line voltage. Phase input connections **2** are provided for inputting analog signals into the device **1**. The magnetic flux concentrator **3** (or a current transformer) senses the incoming analog signal and the volts zero crossing point detector **5** determines the zero volts crossing point of the signal. The positive half cycle and negative half cycle of the signal is identified and routed to the digital signal processor **10** for processing the signal. The signal is reduced by the driver control **15** via pulse width modulation and the reduced amount of energy is outputted, thereby yielding an energy savings for an end user. As shown in FIG. 1, real time clock module **49** is connected with the DSP **10**. The real time clock module **49** may be used to set the predetermined time periods.

The microprocessor **26'** shown in FIG. 18C may measure the AC incoming line voltage, and compare it with the predetermined voltage. When the AC incoming line voltage is higher than the predetermined voltage, the microprocessor controls the switching network **16'** shown in FIG. 18A on the primary windings side of the transformer to short circuit the primary windings. When the measured voltage is less than the predetermined voltage, and voltage increase is needed, such as during a brownout condition, the microprocessor **26'** controls the switching network **16'** to connect one end of the primary windings to neutral, removing the short circuit from the transformer and allowing the secondary voltage to add to the mains input voltage to provide a boosted output voltage through the hot output line of the secondary windings side of the transformer. The voltage may be increased to the predetermined voltage. The secondary windings are not switched.

During a second predetermined period of time, such as when blackout conditions are anticipated, the DSP **10** controls the IGBT/FET-based device **1** shown in FIG. 1 to supply an allocated amount of power, which may be predetermined. The DSP **10** and/or the microprocessor **26'** monitors power consumption, which may be displayed. When the power consumption exceeds the allocated amount, the DSP **10** may shut off the power.

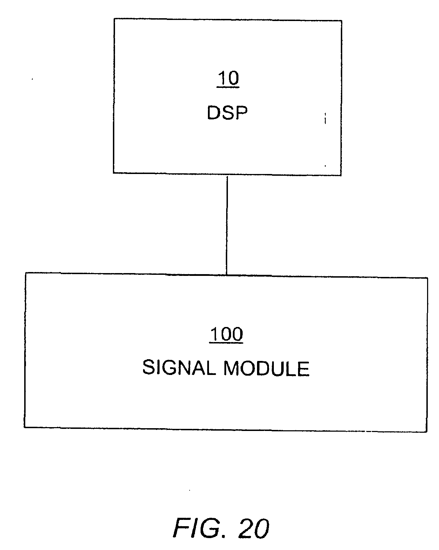

Alternatively, when the consumed power exceeds the allocated power, a signal may be sent alerting the need to reduce power usage. In FIG. 20, signal module **100** is connected with DSP **10** and may provide the signal. The signal may be audible, visible, or other means. The signal module may be a buzzer module, although other modules are also contemplated. Wirelessly controlled electrical outlets may be used to selectively reduce the load in response to the signal. If the load has not been adequately reduced after a predetermined amount of time, the DSP **10** may shut off power. The consumer may then reduce some load, and initiate a command to turn the power back on. The command may be initiated by changing the condition of a switch, including manually and/or wirelessly. If the load has still not been adequately reduced after the power has been restored, then the DSP may again shut off the power. Alternatively, the DSP may provide another signal that may again alert that the load must be reduced. If the consumed power is not reduced sufficiently after a predetermined amount of time, then the DSP may shut off power through the hot output line for the duration of the second predetermined time period.

Further alternatively, when the consumed power exceeds the allocated power, the DSP may shut off power to predetermined electrical outlets, while providing power to other electrical outlets, to reduce the overall power usage to the allocated power amount. The system may use wirelessly controlled electrical outlets that may be automatically shutdown to meet the predetermined power amount. The system and method may use preset consumer preferences to reduce the power consumed. The system may be monitored, operated and adjusted wirelessly.

Energy allocation, such as described above, allows consumers to enjoy electrical power for key appliances rather than have no power at all. There are many times that this action is necessary where there is insufficient electrical power for all consumers. Under such conditions, the electrical company may desire to provide a reduced or allocated service to all consumers, rather than provide service to some consumers and no service at all to others. The consumer may become part of the solution rather than part of the problem.

Through wireless communication there is the ability to communicate between controllers, adapters, and input devices. The display device may utilize an off the shelf computer, iPad, smart phone, or other input device using a keyboard, touch screen or combination thereof. Other devices are also contemplated. An iPad is available from Apple Inc. of Cupertino, California. While an input device may be used to wirelessly monitor, adjust settings, or adjust control parameters, the system may function completely on its own, independent of the input device. Furthermore, the main unit may have full wireless communications to enable remote control of the aforementioned power outlet and adapters. The system may provide full lighting and environment control. The system may allow for a consumer's power usage profile to be input and implemented for power allocation and selective power reduction. The system and method may provide dynamic power allocation.

As can now be understood, the system and method is a conservation power management system that is installed at the point of consumption. The implementation does not require any immediate increase in power generation, nor does it require any immediate enhancement of the power grid. The solution uses an energy management system that saves energy, reduces brown outs and blackouts, and manages usage to reduce costs to the consumer and the electrical generating and distribution company. The management system results in a reduction in copper losses, thereby releasing energy previously wasted as heat and at a financial loss to the electrical company. The conserved energy can be provided to additional consumers, thereby providing additional income to the electrical utility, at no additional costs.

The system and method have at least eight main features: (1) energy conservation and user cost savings, (2) voltage stabilization, (3) uniform electricity costs to consumers, (4) copper loss reduction, (5) hydrocarbon emission mitigation, (6) brownout mitigation, (7) blackout mitigation, and (8) energy allocation.

The system and method provide energy conservation and user cost savings. Electrical power is typically delivered to the consumer at a nominal voltage of 120/127/230 Vrms. This is the target voltage that the electrical company aims to supply. This voltage can disadvantageously fluctuate by plus or minus 10%, or more, within the power company specification, often by a much greater margin. Appliance manufacturers, well aware of the power shortcomings, design their appliances for the low (minus 10%) end of the supply voltage and design the devices to withstand the high (plus 10%) end of the supplied voltage. At the low end, the appliance will perform its task as specified. However, at any voltage above the low voltage, the appliance will be over supplied and will waste electrical energy at a cost to the consumer. The system and method minimize this situation. The invention regulates the AC voltage at the selected low voltage, thereby saving energy.

The system and method provide voltage stabilization. In extreme cases where the delivered voltage falls below the low voltage, the system and method solve this problem by boosting the incoming voltage, such as to allow the voltage regulation to occur. Unlike voltage boosters that are available for single appliances, the boost section of the system maintains the voltage at the low end for the whole home or business. Not only does this improve the quality of service for the consumer, it also allows the removal of unsightly boosters, used in some countries, from the vicinity of specific appliances so equipped.

The system and method provide uniform electricity cost to consumers. In a typical community, the consumers are charged inconsistently for the same amounts of electrical power required, which is a result of inconsistent voltages being supplied to the community. These losses result from copper losses. Electrical conductors impede the flow of electrical current. This shortcoming of all conductors can be planned for, and larger copper conductors can be employed. Increasing the size of the conductor reduces the copper losses. Unfortunately, the existing power distribution networks were not designed to carry the power needs of emerging economies where affluence is accompanied by the desire, on the part of the consumer, to have appliances and entertainment systems to complement the improved life style. The result is that for a community, the power delivered to the consumer closest to the main electricity transformer, has a much higher voltage than that which is delivered to the consumer furthermost removed from the transformer. This unfair situation results in the consumer closest to the transformer paying for more energy than the consumer at the other end, even if both consumers have identical appliances and a similar lifestyle. The product of electrical voltage and current is watts, and higher voltage results in higher wattage. Wattage per hour is what the consumer pays for. This unfair power situation may be resolved by the system and method.

The system and method provide copper loss reduction. Copper losses are the cumulative power distribution losses experienced in all power distribution networks. In most emerging economies the power distribution network is not capable of sustaining the loading imposed when a community attempts to consume quantities of power that the network was not designed for. This situation usually results from an increase in affluence, which is generally accompanied by the ownership of consumer items like air conditioners, central heating, televisions, washers, audio and improved lighting. When the feeder supplying power to the homes in such a community experiences excessive loading, the electrical resistance, present in all conductors, becomes significant, and a portion of the supplied voltage appears across the resistance of the conductor. The product of this voltage together with the current from many consumers causes a power loss (Watts) within the conductor that is dissipated as heat. This represents a major loss of revenue to the electrical company. With the system and method installed and implemented in the homes associated with this section of the network, the power that was otherwise wasted may then be available to other consumers and may result in an improved revenue stream to the electrical company.

The system and method provide hydrocarbon emission mitigation. Hydrocarbon emissions exist when fossil fuels (oil, gas or coal) are used to generate electrical power. The system and method manage the power being consumed with considerable conservation, at the point of consumption. The effect is twofold: first, a reduction in electrical energy results in a reduction in fossil fuel being consumed with the attendant savings of carbon emissions; and second, this can defer the immediate need for additional generation capacity. Either way benefits are accrued and directly affect the carbon bond situation in a positive way.

The system and method provide brownout mitigation. The system and method, just by their implementation, mitigates this problem. However, associated with the system and method is a feature where, at known times susceptible to brownout, the device can be programmed to, automatically, apply an additional percentage of voltage reduction. Under such circumstances, the loading on the network is further reduced and results in further copper loss reduction.

The system and method provide blackout mitigation. The times of blackouts are usually well known to the electrical company. The system and method, at known times susceptible to blackout, automatically monitor the power usage, alert the consumer, and allocate the power such that every consumer gets their rationed amount.

In one embodiment, when the set time is activated and the allocated wattage is being exceeded, an audible warning device alerts the consumer to shed load. Sometime later, if insufficient load has been shed, the system can be automatically shut down. At this point the consumer can shed some load and then change the condition of a switch to bring the system back on line. If insufficient load has been shed, the audible warning device will again alert the consumer to shed more load. If the consumer does not respond, the system may be set to shut down power for the remaining timed period. Other embodiments are contemplated. Various scenarios can be invoked in accordance with the local situation, desires, and needs of the electricity company, at their discretion. Furthermore, wirelessly controlled electrical outlets can be utilized so that the appropriate devices can be automatically shut-down to meet the required load shedding requirements in relation to the allocated power.

The system and method provide energy allocation. Energy allocation described above allows consumers to enjoy electrical power for key appliances rather than have no power at all. There are many times that this action is necessary where there is insufficient electrical power to go around everyone. Under such a scenario, it is fair to provide a reduced service to everyone to an allocated amount rather than provide service to some and no service at all to others. Each consumer is part of the solution rather than part of the problem.

It is to be understood that while embodiments are illustrated, they are not to be limited to the specific form or arrangement of parts herein described and shown. It will be apparent to those skilled in the art that various changes may be made without departing from the scope of the invention as defined in the appended claims.

**Claims**

1. A method for managing electrical power usage, comprising the steps of:

   providing an allocated amount of power during a first predetermined time period through a hot output line of an IGBT/FET based device (1) having a digital signal processor (10); and
   monitoring the power consumed through said hot output line during said first predetermined time period with said digital signal processor;

   wherein said IGBT/FET based device comprises:

   at least one phase input connection (2) configured for inputting a predetermined amount of incoming energy having at least one analog signal into said IGBT/FET based device;
   at least one sensor connected to said at least one phase input connection and configured for sensing said predetermined amount of incoming energy into said IGBT/FET based device;
   at least one volts zero crossing point detector (5) in electrical connection with said at least one phase input connection and configured for determining at least one zero volts crossing point of said at least one analog signal;
   at least one half cycle identifier (8) in electrical connection with said at least one phase input connection and configured for identifying at least one positive half cycle of said at least one analog signal and at least one negative half cycle of said at least one analog signal;
   at least one logic device (9) in electrical connection with said at least one volts zero crossing point detector and said at least one half cycle identifier and configured for routing said at least one positive half cycle of said at least one analog signal and said at least one negative half cycle of said at least one analog signal to said digital signal processor;
   said digital signal processor in electrical connection with said at least one logic device and configured for processing said at least one analog signal;
   at least one voltage reducing means having at least one drive control (15) wherein said at least one voltage reducing means is in electrical connection with said at least one digital signal processor and is configured for reducing said predetermined amount of incoming energy by providing pulse width modulation to the at least one analog signal to yield a reduced amount of energy; and
   at least one phase output connection (17) in electrical connection with said at least one voltage reducing means and configured for outputting said reduced amount of energy out of said IGBT/FET based device; wherein

   the method further comprises sending a first signal with said digital signal processor when the monitored consumed power exceeds said allocated amount of power during said first predetermined time period, the first signal alerting the need to reduce power usage.

2. The method of claim 1, wherein said at least one sensor comprises at least one of: a magnetic flux concentrator (3) and a current transformer.

3. The method of claim 1, wherein said first predetermined time period is during anticipated blackout conditions.

4. The method of claim 1, wherein said first signal is an audible sound or a visible signal.

**5.** The method of claim 1, further comprising the step of:

switching off the power in said hot output line at a predetermined time after said first signal if the monitored consumed power exceeds said allocated amount of power at said predetermined time after said first signal.

**6.** The method of claim 5, wherein:

the method further comprises the step of switching on the power in said hot output line after the step of switching off.

**7.** The method of claim 6, wherein an energy consumer reduces an electrical load and then switches on the power.

**8.** The method of claim 6, wherein switching on occurs in response to a command; and wherein optionally

said command is a change in condition of a command switch.

**9.** The method of claim 1, further comprising the steps of:

receiving an AC incoming line voltage with said IGBT/FET based device during a second predetermined time period;
supplying a predetermined voltage in said hot output line from said IGBT/FET based device that is less than said AC incoming line voltage during said second predetermined time period; and
measuring said AC incoming line voltage during said second predetermined time period.

**10.** The method of claim 9, further comprising the steps of:

providing a transformer (41') with the transformer's secondary windings (2A, 2B)between a hot input line and a hot output line, and the transformer's primary windings (10A, 10B) in electrical connection at a first end with said hot input line and at a second end with an electronic switch;
receiving said AC incoming line voltage in said hot input line;
controlling said electronic switch with a microprocessor to a first condition electrically connecting said primary windings second end with said hot input line when said AC incoming line voltage is greater than said predetermined voltage during said second predetermined time period.

**11.** The method of claim 9, wherein the predetermined voltage that is supplied in the hot output line is determined using one or more of a voltage reduction percentage, a savings reduction percentage, and a desired root mean square voltage output value.

**12.** The method of claim 11, further comprising displaying an amount of energy saved.

**13.** A system for managing electrical power usage, the system comprising:

an IGBT/FET based device (1) having a digital signal processor (10), the IGBT/FET based device being configured to provide an allocated amount of power during a first predetermined time period through a hot output line;
the digital signal processor being configured to monitor the power consumed through said hot output line during said first predetermined time period;
wherein said IGBT/FET based device comprises:

at least one phase input connection (2) configured for inputting a predetermined amount of incoming energy having at least one analog signal into said IGBT/FET based device;
at least one sensor connected to said at least one phase input connection and configured for sensing said predetermined amount of incoming energy into said IGBT/FET based device;
at least one volts zero crossing point detector (5) in electrical connection with said at least one phase input connection and configured for determining at least one zero volts crossing point of said at least one analog signal;
at least one half cycle identifier (8) in electrical connection with said at least one phase input connection and configured for identifying at least one positive half cycle of said at least one analog signal and at least one negative half cycle of said at least one analog signal;

at least one logic device (9) in electrical connection with said at least one volts zero crossing point detector and said at least one half cycle identifier and configured for routing said at least one positive half cycle of said at least one analog signal and said at least one negative half cycle of said at least one analog signal to said digital signal processor;

said digital signal processor in electrical connection with said at least one logic device and configured for processing said at least one analog signal;

at least one voltage reducing means having at least one drive control (15) wherein said at least one voltage reducing means is in electrical connection with said at least one digital signal processor and is configured for reducing said predetermined amount of incoming energy by providing pulse width modulation to the at least one analog signal to yield a reduced amount of energy; and

at least one phase output connection (17) in electrical connection with said at least one voltage reducing means and configured for outputting said reduced amount of energy out of said IGBT/FET based device; wherein

the digital signal processor is configured to send a first signal when the monitored consumed power exceeds said allocated amount of power during said first predetermined time period, the first signal alerting the need to reduce power usage.

**14.** The system of claim 13, wherein said first signal is an audible sound or a visible signal.

**15.** The system of claim 13, wherein the digital signal processor is configured to switch off the power in said hot output line at a predetermined time after said first signal if the monitored consumed power exceeds said allocated amount of power at said predetermined time after said first signal.

**Patentansprüche**

**1.** Verfahren zum Verwalten des Verbrauchs von elektrischer Leistung, die Schritte umfassend:

Bereitstellen eines zugeteilten Leistungsbetrags während eines ersten vorbestimmten Zeitabschnitts über einen Ausgangs-Phasenleiter eines IGBT/FETbasierten Bauelements (1), das einen digitalen Signalprozessor (10) hat; und

Überwachen des über den Ausgangs-Phasenleiter während des ersten vorbestimmten Zeitabschnitts abgenommenen Leistung mit dem digitalen Signalprozessor;

worin das IGBT/FET-basierte Bauelement umfasst:

mindestens eine Phaseneingangsverbindung (2), die zum Eingeben eines vorbestimmten Betrags von in das IGBT/FET-basierte Bauelement eingespeister Energie, die mindestens ein Analogsignal aufweist, konfiguriert ist;

mindestens einen Sensor, der mit der mindestens einen Phaseneingangsverbindung verbunden und zum Erfassen des vorbestimmten Betrags von in das IGBT/FET-basierte Bauelement eingespeister Energie konfiguriert ist;

mindestens einen Null-Volt-Durchgangspunktdetektor (5), der in elektrischer Verbindung mit der mindestens einen Phaseneingangsverbindung steht und zum Bestimmen von mindestens einem Null-Volt-Durchgangspunkt des mindestens einen Analogsignals konfiguriert ist;

mindestens einen Halbwellenidentifizierer (8), der in elektrischer Verbindung mit der mindestens einen Phaseneingangsverbindung steht und zum Identifizieren mindestens einer positiven Halbwelle des mindestens einen Analogsignals und mindestens einer negativen Halbwelle des mindestens einen Analogsignals konfiguriert ist;

mindestens ein Logikbauelement (9), das in elektrischer Verbindung mit dem mindestens einen Null-Volt-Durchgangspunktdetektor und dem mindestens einen Halbwellenidentifizierer steht und zum Weiterleiten der mindestens einen positiven Halbwelle des mindestens einen Analogsignals und der mindestens einen negativen Halbwelle des mindestens einen Analogsignals zu dem digitalen Signalprozessor konfiguriert ist;

wobei der digitale Signalprozessor in elektrischer Verbindung mit dem mindestens einen Logikbauelement steht und zum Verarbeiten des mindestens einen Analogsignals konfiguriert ist;

mindestens ein Spannungsverringerungsmittel mit mindestens einer Treibersteuerung (15), worin das mindestens eine Spannungsverringerungsmittel in elektrischer Verbindung mit dem mindestens einen digitalen Signalprozessor steht und zum Verringern des vorbestimmten Betrags von eingespeister Energie durch Bereitstellen von Pulsweitenmodulation für das mindestens eine Analogsignal, um einen verringerten Energiebetrag zu ergeben, konfiguriert ist; und

mindestens eine Phasenausgangsverbindung (17), die in elektrischer Verbindung mit dem mindestens einen Spannungsverringerungsmittel steht und zum Ausgeben des verringerten Energiebetrags aus dem IGBT/FET-basierten Bauelement konfiguriert ist; worin

das Verfahren ferner umfasst: Senden eines ersten Signals mit dem digitalen Signalprozessor, wenn die überwachte abgenommene Leistung während des ersten vorbestimmten Zeitabschnitts den zugeteilten Leistungsbetrag übersteigt, wobei das erste Signal auf die Notwendigkeit hinweist, den Leistungsverbrauch zu verringern.

2. Verfahren nach Anspruch 1, worin der mindestens eine Sensor mindestens eines von Folgendem umfasst: ein Magnetflusskonzentrator (3) und ein Stromwandler.

3. Verfahren nach Anspruch 1, worin der erste vorbestimmte Zeitabschnitt während erwarteter Stromausfallbedingungen ist.

4. Verfahren nach Anspruch 1, worin das erste Signal ein hörbarer Ton oder ein sichtbares Signal ist.

5. Verfahren nach Anspruch 1, ferner den Schritt umfassend:

Ausschalten der Leistung in dem Ausgangs-Phasenleiter zu einer vorbestimmten Zeit nach dem ersten Signal, wenn die überwachte abgenommene Leistung zu der vorbestimmten Zeit nach dem ersten Signal den zugeteilten Leistungsbetrag übersteigt.

6. Verfahren nach Anspruch 5, worin:

das Verfahren ferner den Schritt umfasst: Einschalten der Leistung in dem Ausgangs-Phasenleiter nach dem Schritt des Ausschaltens.

7. Verfahren nach Anspruch 6, worin ein Energieverbraucher eine elektrische Last verringert und dann die Leistung einschaltet.

8. Verfahren nach Anspruch 6, worin das Einschalten als Antwort auf einen Befehl erfolgt; und worin optional der Befehl eine Änderung des Zustands eines Befehlsschalters ist.

9. Verfahren nach Anspruch 1, ferner die Schritte umfassend:

Empfangen einer Speiseleitungs-Wechselspannung mit dem IGBT/FET-basierten Bauelement während eines zweiten vorbestimmten Zeitabschnitts;
Einspeisen einer vorbestimmten Spannung, die niedriger als die Speiseleitungs-Wechselspannung ist, aus dem IGBT/FET-basierten Bauelement in den Ausgangs-Phasenleiter während des zweiten vorbestimmten Zeitabschnitts; und
Messen der Speiseleitungs-Wechselspannung während des zweiten vorbestimmten Zeitabschnitts.

10. Verfahren nach Anspruch 9, ferner die Schritte umfassend:

Bereitstellen eines Transformators (41') mit den Sekundärwicklungen (2A, 2B) des Transformators zwischen einem Eingangs-Phasenleiter und einem Ausgangs-Phasenleiter und den Primärwicklungen (10A, 10B) des Transformators in elektrischer Verbindung an einem ersten Ende mit dem Eingangs-Phasenleiter und an einem zweiten Ende mit einem elektronischen Schalter;
Empfangen der Speiseleitungs-Wechselspannung in dem Eingangs-Phasenleiter;
Steuern des elektronischen Schalters mit einem Mikroprozessor in einen ersten Zustand, der das zweite Ende der Primärwicklungen elektrisch mit dem Eingangs-Phasenleiter verbindet, wenn die Speiseleitungs-Wechselspannung während des zweiten vorbestimmten Zeitabschnitts größer als die vorbestimmte Spannung ist.

11. Verfahren nach Anspruch 9, worin die vorbestimmte Spannung, die in den Ausgangs-Phasenleiter eingespeist wird, unter Verwendung von einem oder mehreren von Folgendem bestimmt wird: ein Spannungsverringerungsprozentsatz, ein Einsparungsverringerungsprozentsatz und ein erwünschter Ausgangsspannungs-Effektivwert.

**12.** Verfahren nach Anspruch 11, ferner umfassend: Anzeigen eines Betrags von eingesparter Energie.

**13.** System zum Verwalten des Verbrauchs von elektrischer Leistung, wobei das System umfasst:

ein IGBT/FET-basiertes Bauelement (1), das einen digitalen Signalprozessor (10) hat, wobei das IGBT/FET-basierte Bauelement dafür konfiguriert ist, während eines ersten vorbestimmten Zeitabschnitts einen zugeteilten Leistungsbetrag über einen Ausgangs-Phasenleiter bereitzustellen;
wobei der digitale Signalprozessor dafür konfiguriert ist, den über den Ausgangs-Phasenleiter während des ersten vorbestimmten Zeitabschnitts abgenommenen Leistung zu überwachen;
worin das IGBT/FET-basierte Bauelement umfasst:

mindestens eine Phaseneingangsverbindung (2), die zum Eingeben eines vorbestimmten Betrags von in das IGBT/FET-basierte Bauelement eingespeister Energie, die mindestens ein Analogsignal aufweist, konfiguriert ist;
mindestens einen Sensor, der mit der mindestens einen Phaseneingangsverbindung verbunden und zum Erfassen des vorbestimmten Betrags von in das IGBT/FET-basierte Bauelement eingespeister Energie konfiguriert ist;
mindestens einen Null-Volt-Durchgangspunktdetektor (5), der in elektrischer Verbindung mit der mindestens einen Phaseneingangsverbindung steht und zum Bestimmen von mindestens einem Null-Volt-Durchgangspunkt des mindestens einen Analogsignals konfiguriert ist;
mindestens einen Halbwellenidentifizierer (8), der in elektrischer Verbindung mit der mindestens einen Phaseneingangsverbindung steht und zum Identifizieren mindestens einer positiven Halbwelle des mindestens einen Analogsignals und mindestens einer negativen Halbwelle des mindestens einen Analogsignals konfiguriert ist;
mindestens ein Logikbauelement (9), das in elektrischer Verbindung mit dem mindestens einen Null-Volt-Durchgangspunktdetektor und dem mindestens einen Halbwellenidentifizierer steht und zum Weiterleiten der mindestens einen positiven Halbwelle des mindestens einen Analogsignals und der mindestens einen negativen Halbwelle des mindestens einen Analogsignals zu dem digitalen Signalprozessor konfiguriert ist;
wobei der digitale Signalprozessor in elektrischer Verbindung mit dem mindestens einen Logikbauelement steht und zum Verarbeiten des mindestens einen Analogsignals konfiguriert ist;
mindestens ein Spannungsverringerungsmittel mit mindestens einer Treibersteuerung (15), worin das mindestens eine Spannungsverringerungsmittel in elektrischer Verbindung mit dem mindestens einen digitalen Signalprozessor steht und zum Verringern des vorbestimmten Betrags von eingespeister Energie durch Bereitstellen von Pulsweitenmodulation für das mindestens eine Analogsignal, um einen verringerten Energiebetrag zu ergeben, konfiguriert ist; und
mindestens eine Phasenausgangsverbindung (17), die in elektrischer Verbindung mit dem mindestens einen Spannungsverringerungsmittel steht und zum Ausgeben des verringerten Energiebetrags aus dem IGBT/FET-basierten Bauelement konfiguriert ist; worin

der digitale Signalprozessor dafür konfiguriert ist, ein erstes Signal zu senden, wenn die überwachte abgenommene Leistung während des ersten vorbestimmten Zeitabschnitts den zugeteilten Leistungsbetrag übersteigt, wobei das erste Signal auf die Notwendigkeit hinweist, den Stromverbrauch zu verringern.

**14.** System nach Anspruch 13, worin das erste Signal ein hörbarer Ton oder ein sichtbares Signal ist.

**15.** System nach Anspruch 13, worin der digitale Signalprozessor dafür konfiguriert ist, die Leistung in dem Ausgangs-Phasenleiter zu einer vorbestimmten Zeit nach dem ersten Signal auszuschalten, wenn die überwachte abgenommene Leistung zu der vorbestimmten Zeit nach dem ersten Signal den zugeteilten Leistungsbetrag übersteigt.

**Revendications**

**1.** Procédé de gestion de consommation électrique, comprenant les étapes ci-dessous consistant à :

fournir une quantité de puissance affectée au cours d'une première période de temps prédéterminée à travers une ligne de sortie à chaud d'un dispositif à base de transistor IGBT/FET (1) présentant un processeur de signal numérique (10) ; et

surveiller la puissance consommée à travers ladite ligne de sortie à chaud au cours de ladite première période de temps prédéterminée avec ledit processeur de signal numérique ;

dans lequel ledit dispositif à base de transistor IGBT/FET comprend :

au moins une connexion d'entrée de phase (2) configurée de manière à entrer une quantité prédéterminée d'énergie entrante, présentant au moins un signal analogique, dans ledit dispositif à base de transistor IGBT/FET ;

au moins un capteur connecté à ladite au moins une connexion d'entrée de phase et configuré de manière à détecter ladite quantité prédéterminée d'énergie entrante dans ledit dispositif à base de transistor IGBT/FET ;

au moins un détecteur de point de passage à zéro volt (5) en connexion électrique avec ladite au moins une connexion d'entrée de phase et configuré de manière à déterminer au moins un point de passage à zéro volt dudit au moins un signal analogique ;

au moins un identificateur de demi-cycle (8) en connexion électrique avec ladite au moins une connexion d'entrée de phase et configuré de manière à identifier au moins un demi-cycle positif dudit au moins un signal analogique et au moins un demi-cycle négatif dudit au moins un signal analogique ;

au moins un dispositif logique (9) en connexion électrique avec ledit au moins un détecteur de point de passage à zéro volt et ledit au moins un identificateur de demi-cycle et configuré de manière à acheminer ledit au moins un demi-cycle positif dudit au moins un signal analogique et ledit au moins un demi-cycle négatif dudit au moins un signal analogique vers ledit processeur de signal numérique ;

ledit processeur de signal numérique étant en connexion électrique avec ledit au moins un dispositif logique et étant configuré de manière à traiter ledit au moins un signal analogique ;

au moins un moyen de réduction de tension présentant au moins une commande d'excitation (15), dans lequel ledit au moins un moyen de réduction de tension est en connexion électrique avec ledit au moins un processeur de signal numérique et est configuré de manière à réduire ladite quantité prédéterminée d'énergie entrante en fournissant une modulation d'impulsions en durée audit au moins un signal analogique en vue de produire une quantité réduite d'énergie ; et

au moins une connexion de sortie de phase (17) en connexion électrique avec ledit au moins un moyen de réduction de tension et configurée de manière à générer en sortie ladite quantité réduite d'énergie hors dudit dispositif à base de transistor IGBT/FET ; dans lequel

le procédé comprend en outre l'étape consistant à envoyer un premier signal avec ledit processeur de signal numérique, lorsque la puissance consommée surveillée dépasse ladite quantité de puissance affectée au cours de ladite première période de temps prédéterminée, le premier signal alertant sur la nécessité de réduire la consommation électrique.

2. Procédé selon la revendication 1, dans lequel ledit au moins un capteur comprend au moins l'un parmi : un concentrateur de flux magnétique (3) et un transformateur de courant.

3. Procédé selon la revendication 1, dans lequel ladite première période de temps prédéterminée correspond à des états de panne anticipés.

4. Procédé selon la revendication 1, dans lequel ledit premier signal est un son audible ou un signal visible.

5. Procédé selon la revendication 1, comprenant en outre l'étape ci-dessous consistant à :

mettre hors tension l'alimentation dans ladite ligne de sortie à chaud à un instant prédéterminé après ledit premier signal, si la puissance consommée surveillée dépasse ladite quantité de puissance affectée audit instant prédéterminé après ledit premier signal.

6. Procédé selon la revendication 5, dans lequel :

le procédé comprend en outre l'étape consistant à mettre sous tension l'alimentation dans ladite ligne de sortie à chaud suite à l'étape de mise hors tension.

7. Procédé selon la revendication 6, dans lequel un module de consommation d'énergie réduit une charge électrique, et effectue ensuite une mise sous tension.

8. Procédé selon la revendication 6, dans lequel la mise sous tension se produit en réponse à une commande ; et dans lequel facultativement

ladite commande est un changement dans l'état d'un commutateur de commande.

9. Procédé selon la revendication 1, comprenant en outre les étapes ci-dessous consistant à :

recevoir une tension de ligne entrante de courant alternatif avec ledit dispositif à base de transistor IGBT/FET au cours d'une seconde période de temps prédéterminée ;

fournir une tension prédéterminée dans ladite ligne de sortie à chaud, à partir dudit dispositif à base de transistor IGBT/FET, laquelle est inférieure à ladite tension de ligne entrante de courant alternatif au cours de ladite seconde période de temps prédéterminée ; et

mesurer ladite tension de ligne entrante de courant alternatif au cours de ladite seconde période de temps prédéterminée.

10. Procédé selon la revendication 9, comprenant en outre les étapes ci-dessous consistant à :

fournir un transformateur (41') avec les enroulements secondaires du transformateur (2A, 2B) entre une ligne d'entrée à chaud et une ligne de sortie à chaud, et les enroulements primaires du transformateur (10A, 10B) en connexion électrique au niveau d'une première extrémité avec ladite ligne d'entrée à chaud et au niveau d'une seconde extrémité avec un commutateur électronique ;

recevoir ladite tension de ligne entrante de courant alternatif dans ladite ligne d'entrée à chaud ;

commander ledit commutateur électronique avec un microprocesseur sur un premier état connectant électriquement ladite seconde extrémité d'enroulements primaires à ladite ligne d'entrée à chaud, lorsque ladite tension de ligne entrante de courant alternatif est supérieure à ladite tension prédéterminée au cours de ladite seconde période de temps prédéterminée.

11. Procédé selon la revendication 9, dans lequel la tension prédéterminée qui est fournie dans la ligne de sortie à chaud est déterminée en utilisant une ou plusieurs caractéristiques parmi un pourcentage de réduction de tension, un pourcentage de réduction d'économies et une valeur de sortie de tension de moyenne quadratique souhaitée.

12. Procédé selon la revendication 11, comprenant en outre l'étape consistant à afficher une quantité d'énergie économisée.

13. Système destiné à gérer une consommation électrique, le système comprenant :

un dispositif à base de transistor IGBT/FET (1) présentant un processeur de signal numérique (10), le dispositif à base de transistor IGBT/FET étant configuré de manière à fournir une quantité de puissance affectée au cours d'une première période de temps prédéterminée à travers une ligne de sortie à chaud ; et

le processeur de signal numérique étant configuré de manière à surveiller la puissance consommée à travers ladite ligne de sortie à chaud au cours de ladite première période de temps prédéterminée ;

dans lequel ledit dispositif à base de transistor IGBT/FET comprend :

au moins une connexion d'entrée de phase (2) configurée de manière à entrer une quantité prédéterminée d'énergie entrante, présentant au moins un signal analogique, dans ledit dispositif à base de transistor IGBT/FET ;

au moins un capteur connecté à ladite au moins une connexion d'entrée de phase et configuré de manière à détecter ladite quantité prédéterminée d'énergie entrante dans ledit dispositif à base de transistor IGBT/FET ;

au moins un détecteur de point de passage à zéro volt (5) en connexion électrique avec ladite au moins une connexion d'entrée de phase et configuré de manière à déterminer au moins un point de passage à zéro volt dudit au moins un signal analogique ;

au moins un identificateur de demi-cycle (8) en connexion électrique avec ladite au moins une connexion d'entrée de phase et configuré de manière à identifier au moins un demi-cycle positif dudit au moins un signal analogique et au moins un demi-cycle négatif dudit au moins un signal analogique ;

au moins un dispositif logique (9) en connexion électrique avec ledit au moins un détecteur de point de passage à zéro volt et ledit au moins un identificateur de demi-cycle et configuré de manière à acheminer ledit au moins un demi-cycle positif dudit au moins un signal analogique et ledit au moins un demi-cycle négatif dudit au moins un signal analogique vers ledit processeur de signal numérique ;

ledit processeur de signal numérique étant en connexion électrique avec ledit au moins un dispositif logique et étant configuré de manière à traiter ledit au moins un signal analogique ;

au moins un moyen de réduction de tension présentant au moins une commande d'excitation (15), dans lequel ledit au moins un moyen de réduction de tension est en connexion électrique avec ledit au moins un processeur de signal numérique et est configuré de manière à réduire ladite quantité prédéterminée d'énergie entrante en fournissant une modulation d'impulsions en durée audit au moins un signal analogique en vue de produire une quantité réduite d'énergie ; et

au moins une connexion de sortie de phase (17) en connexion électrique avec ledit au moins un moyen de réduction de tension et configurée de manière à générer en sortie ladite quantité réduite d'énergie hors dudit dispositif à base de transistor IGBT/FET ; dans lequel

le processeur de signal numérique est configuré de manière à envoyer un premier signal lorsque la puissance consommée surveillée dépasse ladite quantité de puissance affectée au cours de ladite première période de temps prédéterminée, le premier signal alertant sur la nécessité de réduire la consommation électrique.

14. Système selon la revendication 13, dans lequel ledit premier signal est un son audible ou un signal visible.

15. Système selon la revendication 13, dans lequel le processeur de signal numérique est configuré de manière à mettre hors tension l'alimentation dans ladite ligne de sortie à chaud à un instant prédéterminé après ledit premier signal, si la puissance consommée surveillée dépasse ladite quantité de puissance affectée audit instant prédéterminé après ledit premier signal.

FIG. 1

FIG. 2

FIG. 5

FIG. 7

FIG. 3

*FIG. 4*

*FIG. 6*

EP 2 622 713 B1

*FIG. 8*

*FIG. 9*

*FIG. 10*

FIG. 11A

FIG. 11B

71

+3.3V

| 1 | 2 |
| 3 | 4 |
| 5 | 6 |
| 7 | 8 |
| 9 | 10 |

GND

*FIG. 11C*

+3.3V

53

79

63

63

63

63

GND

*FIG. 11D*

80

| 3 |
| 5 |
| 7 |

GND

*FIG. 11E*

21

*FIG. 12A*

FIG. 12B

FIG. 12C

FIG. 12D

FIG. 12E

FIG. 12F

FIG. 12C

EP 2 622 713 B1

EP 2 622 713 B1

| FIG. 14A | FIG. 14B |
|----------|----------|

FIG. 14A

FIG. 13

FIG. 14B

FIG. 15B

FIG. 15C

*FIG. 15A*

*FIG. 15D*

*FIG. 15E*

EP 2 622 713 B1

Settings ☒

**Operational Mode** — 43 — 42
- ○ Voltage Regulation (RMS)
- ⦿ Voltage Reduction (%)
- ○ Savings Reduction (%)

**Phase** — 44 — 42
- ○ Single Phase
- ○ Bi-Phase
- ⦿ Three Phase

**Setpoints** — 47 — 42 — 41

Operational Mode: [Voltage Reduction]

*Voltage Regulation*

Setpoint (RMS) [107.0]

*Voltage Reduction*

Voltage Reduction (%) [9]

Lower Limit (RMS) [107.0]

*Savings Reduction*

Savings Reduction (%) [0]

Lower Limit (RMS) [107.0]

45 — **Operational Mode**
Enable Random Start ☑
42 — Soft Start Time (Secs) [2]

46 — **Calibration**

|  | PH-1 | Ph-2 | Ph-3 |
|---|---|---|---|
| Input Calibration Factor | 1.00 | 1.00 | 1.00 |
| Output Calibration Factor | 1.00 | 1.00 | 1.00 |
| Current Calibration Factor | 1.00 | 1.00 | 1.00 |

42 —
- ⦿ Right Rotation
- ○ Left Rotation

[ OK ]　[ Cancel ]

*FIG. 16*

FIG. 17

FIG. 18A

EP 2 622 713 B1

FIG. 18B

FIG. 18C

FROM FIG. 18A

J1

+5V

26'    30'

TRIAC DRV 1

+5V

R12

R14

R15

LINE V

NEUTRAL

R21    R10

R22    R9

R23

TRIAC DRV 2

32'

| 1 | 2 |
| 3 | 4 |
| 5 | 6 |

RA0/AN0/C1IN+ICSPDAT          RC0/AN4/C2IN+
RA1/AN1/C1IN-VREF/ICSPCLK     RC1/AN5/C2IN-
RA2/AN2/T0CKI/INT/C1OUT            RC2/AN6
RA3/MCLR/VPP                       RC3/AN7
RA4/AN3/T1G/OSC2/CLCOUT  RC4/C2OUT/TX/CK
RA5/T1CKI/OSC1/CLKIN              RC5/RX/DT

VSS                                  VDD

+5V

NEUTRAL

C8

R47    +5V

MICROPROCESSOR
SECTION

EP 2 622 713 B1

FIG. 19

FIG. 19A

EP 2 622 713 B1

FIG. 19B

TO FIG. 19C

TO FIG. 19C

FROM FIG. 19 OR 19A

EP 2 622 713 B1

FIG.19C

| JUMPER VOLTAGE SELECT | | | |
|---|---|---|---|
| SET V | 1&2 | 3&4 | 5&6 |
| 200 V | OUT | OUT | OUT |
| 190 V | IN | OUT | OUT |
| 180 V | OUT | IN | OUT |
| 170 V | IN | IN | OUT |
| 160 V | OUT | OUT | IN |
| 210 V | IN | OUT | IN |
| OPTION 1 | OUT | IN | IN |
| OPTION 2 | IN | IN | IN |

EP 2 622 713 B1

```
┌─────────────────────────┐
│                         │
│           10            │
│                         │
│          DSP            │
│                         │
│                         │
└─────────────────────────┘
            │
            │
┌───────────────────────────────┐
│                               │
│             100               │
│                               │
│        SIGNAL MODULE          │
│                               │
│                               │
└───────────────────────────────┘
```

*FIG. 20*

**EP 2 622 713 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090051344 A
- US 20090200981 A
- US 20100033155 A
- US 6489742 B
- US 20100117588 A
- US 20100320956 A